(19) Europäisches Patentamt
European Patent Office
Office européen des brevets

(11) Numéro de publication: **0 153 264**
**B1**

(12) # FASCICULE DE BREVET EUROPÉEN

(45) Date de publication du fascicule du brevet: **18.05.88**

(51) Int. Cl.⁴: **H 04 L 7/04,** H 04 J 3/06, H 04 L 27/14, H 03 G 3/20, H 04 N 7/00

(21) Numéro de dépôt: **85460002.0**

(22) Date de dépôt: **30.01.85**

(54) **Système de radiodiffusion de données, notamment vers des postes mobiles.**

(30) Priorité: **15.02.84 FR 8402623**

(43) Date de publication de la demande: **28.08.85 Bulletin 85/35**

(45) Mention de la délivrance du brevet: **18.05.88 Bulletin 88/20**

(84) Etats contractants désignés: **AT BE CH DE GB IT LI LU NL SE**

(56) Documents cité:
**EP-A-0 077 712**
**EP-A-0 096 854**
**FR-A-2 313 825**

**PATENTS ABSTRACTS OF JAPAN, volume 7, no. 292, 27 décembre 1983, page 136E219; & JP - A - 58 168 347 (MITSUBISHI DENKI K.K.) 04-10-1983**
**INGENIEUR, volume 81, no. 40, 3 octobre 1969, page ET 151, NL; C.J. VAN ELK: "Rastersynchronisatie van PCM-signalen bij radio-transmissie"**
**IEEE TRANSACTIONS ON COMMUNICATIONS, volume COM-28, no. 6, 6 juin 1980, pages 850-857, New York, US; MITSURU ISHIZUKA et al.: "Optimum gaussian filter and deviated-frequency-locking scheme for coherent detection of MSK"**

(73) Titulaire: **Etablissement Public de Diffusion dit "Télédiffusion de France", 21- 27 rue Barbès, F-92120 Montrouge (FR)**

(72) Inventeur: **Collec, Jean Pierre, 18 Place du Maréchal Juin, F-35000 Rennes (FR)**
Inventeur: **Rigal, Michel Roger, Le Haut Chatenay, Corps Nuds, F-35150 Janze (FR)**

(74) Mandataire: **Le Guen, Louis François, Cabinet Louis Le Guen 1, avenue Edouard VII B.P. 91, F-35802 Dinard Cédex (FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

**EP 0 153 264 B1**

LIBER, STOCKHOLM 1988

**Description**

La présente invention concerne un système de radiodiffusion de paquets de données pouvant provenir de diverses sources et plus spécialement destinées à être reçues dans des récepteurs mobiles, généralement installés à bord de véhicules. Bien entendu, les données radiodiffusées peuvent également être reçues dans des récepteurs tixes.

La réception de données dans un récepteur de véhicule présente des difficultés spécifiques. En effet, du fait du déplacement du véhicule, les conditions de réception se modifient sans cesse, comme les perturbations susceptibles d'affecter le signal reçu.

De plus, l'antenne de réception, placée sur le véhicule, se trouve à une hauteur d'environ 1,5 m et, pour des raisons évidentes, il est pratiquement impossible d'utiliser une antenne de réception directive.

Enfin, lorsque le véhicule contenant le récepteur mobile se déplace dans une région fortement urbanisée, les réflexions très nombreuses des signaux sur les immeubles environnants engendrent un signal reçu composite, dont la complexité peut être grande. En particulier, quand les réflexions sont très nombreuses, on peut montrer que l'enveloppe du champ électrique composite reçu possède une densité de probabilité qui suit une loi de Rayleigh.

Pratiquement, cela signifie que, pendant le déplacement du véhicule, le champ reçu, c'est-à-dire le signal à l'entrée du récepteur mobile, aura une valeur qui pourra varier très rapidement. En particulier, il est possible de remarquer des affaiblissements très rapides du signal, espacés en moyenne d'une valeur correspondant à la demi-longueur d'onde de la fréquence porteuse utilisée. L'effet de ces affaiblissements dépend de la vitesse du véhicule et du débit de données. L'importance des évanouissements est également variable, mais souvent comprise entre 10 et 20 dB au-dessous du niveau moyen reçu.

Enfin, il existe une autre catégorie de perturbations que sont les parasites et, en particulier, ceux qui sont créés par les activités humaines. L'importance de leur gêne varie en fonction de la bande de fréquence utilisée. Les sources les plus importantes de ces parasites sont les circuits d'allumage des véhicules, certaines installations industrielles utilisant des courants haute-fréquence et les isolateurs défectueux des lignes électriques de distribution haute et moyenne tension.

Toutes ces perturbations concourent à dégrader la qualité du signal reçu et, comme l'information est constituée par des données numériques, les dégradations se manifestent par un accroissement du nombre de bits reçus erronés. En pratique, les expériences de radiodiffusion de données reçues dans des récepteurs mobiles ont montré que le taux d'erreurs est sujet à des fluctuations rapides et parfois considérables autour d'une valeur moyenne déterminée pendant un temps de réception important par rapport au débit (de l'ordre de plusieurs minutes). Ces fluctuations sont effectivement dues, non seulement aux variations du niveau du signal reçu, mais encore aux parasites radioélectriques.

Une analyse fine montre l'existence de "salves" d'erreurs correspondant à des augmentations importantes et localisées du taux d'erreurs. Ces salves dont la taille peut parfois atteindre plusieurs milliers d'octets consécutifs faux, c'est-à-dire contenant au moins une erreur, conduisent à prévoir, d'une part, une détection d'erreurs particulièrement efficace et, d'autre part, à procéder à des répétitions de paquets. En effet, dans les conditions mentionnées ci-dessus, l'utilisation d'une stratégie de correction pour augmenter la fiabilité des messages diffusés conduirait à employer des codes à grande capacité de correction nécessitant généralement un décodage complexe, ce qui augmenterait le coût du récepteur.

En pratique, la conception d'un système fiable de radiodiffusion de paquets de données conduit à effectuer d'abord des choix dans des techniques connues, puis à perfectionner certains aspects de ces techniques pour les adapter au mieux au résultat désiré. Ces choix concernent notamment la bande de fréquences à utiliser, la modulation, le débit des données, le mode de détection des débuts des paquets et le codage utilisé pour la détection des erreurs, et la stratégie de répétition des paquets. En pratique, certains de ces choix ne sont pas sans liaison entre eux. Il faut encore tenir compte du fait que le systéme de radiodiffusion doit être capable de diffuser des paquets de données provenant de diverses sources, c'est-à-dire qu'il s'agit d'un système multiservices, capable de traiter aussi bien des textes alphanumériques que des données graphiques ou de la parole synthétique.

En ce qui concerne les bandes de fréquences, on doit tenir compte de l'encombrement du spectre et des contraintes légales nationales et internationales. Dans l'exemple qui va être décrit en détail dans la suite, la fréquence porteuse HF utilisée sera de 67,75 MHz.

Le choix de la modulation résulte d'un compromis entre différents paramètres: les performances de la modulation vis-à-vis du bruit, son rendement, c'est-à-dire le débit numérique qu'elle autorise dans un spectre donné, sa résistance vis-à-vis des distorsions linéaires et non linéaires et, enfin, la complexité du démodulateur qui détermine son coût. La modulation de type MSK simplifiée, par exemple celle qui est décrite dans le brevet FR-A-2 428 345, répond à ce compromis. Il s'agit d'une modulation de phase à deux états et bande latérale atténuée. Vis-à-vis du bruit, les performances théoriques de cette modulation sont les mêmes que celles des modulations à 2 ou 4 états de phase à démodulation cohérente. C'est une modulation à enveloppe constante qui possède donc une excellente résistance aux distorsions. Son utilisation conduit à un démodulateur de structure et de complexité voisines de celles d'un démodulateur MDP2.

Dans l'exemple qui sera décrit, le débit est de 30 kbit/s, ce débit permettant, à la réception, un traitement complet par logiciel. On pourrait prévoir des débits plus élevés en utilisant des automates câblés.

En ce qui concerne la détection des débuts de paquets, il est avantageux que les débuts de paquet soient périodiques pour obtenir, en quelque sorte, une synchronisation du système.

Dans le brevet EP-A-0 044 780, il est déjà décrit un système de multiplexage de paquets de données numériques transmises sur un support de transmission à porteuse transmise d'une manière continue, telle que, par exemple, un porteuse radiodiffusée par satellite ou un réseau terrestre. Dans ce système, les paquets de données (Bi) sont individuellement inclus dans des blocs de transmission (Pi) qui sont émis périodiquement sur une porteuse modulée numériquement. Si l'on considère l'horloge du train numérique des données transmises, la période d'émission des blocs de transmission (Pi) est égale à I impulsions d'horloge. La période de répétition des débuts de paquets est égale ou légèrement supérieure à la longueur maximale d'un bloc de transmission. Le début de chaque bloc de transmission comprend un motif de synchronisation (Ei).

Toutefois, comme le mentionne clairement le préambule du brevet EP-A-0 044 780, le système y est particulièrement destiné à la radiodiffusion de données par satellites ou réseaux terrestres utilisant des canaux à forte capacité pour obtenir des liaisons d'excellente qualité. En pratique, les signaux ainsi diffusés ont un niveau qui évolue beaucoup plus lentement que les niveaux des signaux reçus par les récepteurs mobiles. Les circuits de synchronisation des Figs. 5 et 9 - 10 du brevet EP-A-0 044 780 sont satisfaisants dans une diffusion par satellite. Ainsi, le graphe de la Fig. 10 montre que la synchronisation est conservée pendant 12 périodes consécutives malgré la non reconnaissance du motif de synchronisation et que seules trois reconnaissances successives de ce motif permettent d'accrocher le système.

Avec des paquets d'une quarantaine d'octets par exemple, et un débit de 30 kbit/s mentionné ci-dessus, le circuit de synchronisation du brevet EP-A-0 044 780 ne décroche qu'au bout d'environ 130 ms et nécessite 40 ms pour se raccrocher. Or, dans la réception à bord de mobiles, le niveau du signal peut se dégrader et se rétablir dans des temps beaucoup plus courts. Le circuit connu entrainerait trop longtemps la poursuite du traitement de paquets qui sont très probablement erronés et retarderait indûment la reprise du traitement. C'est pourquoi un objet de la présente invention consiste à prévoir un mode de synchronisation permettant de mieux tenir compte de l'allure des variations du niveau du signal d'entrée d'un récepteur mobile.

Etant donné, comme on l'a mentionné plus haut, que l'on a prévu de répéter plusieurs fois les paquets, il a paru également intéressant d'utiliser un système de groupement des données tel que celui qui est décrit dans la demande de brevet EP-A-0 077 712. Dans ce mode de groupement, les données émises par chaque source sont arrangées en groupes de données, chaque groupe étant formé d'une séquence de blocs de données. Chaque bloc de données forme le champ de données d'un paquet. Autrement dit, chaque paquet est constitué par un bloc de données précédé d'un préfixe qui contient des signaux de synchronisation de bits et d'octets, un code d'identification de source, un signal d'indice de continuité de paquet et une information sur la structure du paquet. De plus, le premier bloc d'un groupe comporte un en-tête de groupe formé d'octets définissant le type de groupe, l'indice de continuité de groupe, le nombre de blocs du groupe qui suivent le premier bloc et la taille du dernier bloc du groupe, tous les blocs sauf le dernier ayant la taille maximale. Le préfixe de chaque paquet comprend, en outre, une information indiquant si le bloc du paquet considéré est le premier bloc d'un groupe ou non.

De plus, l'en-tête du premier bloc d'un groupe comporte une information indiquant le nombre de fois que le groupe sera encore répété. Enfin, chaque bloc de données se termine par un certain nombre d'octets de contrôle de bloc formant un suffixe.

Ces objets de l'invention sont atteints suivant une méthode et par la mise en oeuvre de combinaisons de moyens définis dans les revendications complétant la présente description.

Les caractéristiques de l'invention mentionnées ci-dessus, ainsi que d'autres, apparaîtront plus clairement à la lecture de la description suivante d'un exemple de réalisation, ladite description étant faite en relation avec les dessins joints, parmi lesquels:

la Fig. 1 est le bloc-diagramme d'un récepteur de données suivant l'invention,

les Figs. 2a et 2b sont des diagrammes schématiques illustrant les structures de trains binaires en différents points du récepteur de la Fig. 1,

la Fig. 3 est un bloc-diagramme fonctionnel illustrant le fonctionnement du module de synchronisation de début de paquet du récepteur de la Fig. 1,

la Fig. 4 est un graphe illustrant le fonctionnement du module de synchronisation de la Fig. 2,

la Fig. 5 est le bloc-diagramme fonctionnel illustrant le fonctionnement du module d'exploitation de données du récepteur de la Fig. 1,

la Fig. 6 est un schéma logiciel illustrant le fonctionnement du module d'exploitation de la Fig. 5,

la Fig. 7 est un schéma illustrant la répartition mémoire d'une interface commune aux trois modules du logiciel de la Fig. 6,

la Fig. 8 est un schéma d'une interface entre le module d'entrée et le module principal du logiciel de la Fig. 6,

la Fig. 9 est le schéma de l'interface entre le module principal et le module de sortie du logiciel de la Fig. 6,

la Fig. 10 est le schéma de la partie HF et FI du récepteur de la Fig. 1,

la Fig. 11 est le schéma des circuits de commande automatique de gain HF et FI utilisés dans la partie de récepteur de la Fig. 10,

la Fig. 12 est le bloc-diagramme du démodulateur du récepteur de la Fig. 1,

la Fig. 13 est le schéma du démodulateur de la Fig. 12, et

les Figs. 14a et 14b sont des formes d'onde illustrant le fonctionnement du démodulateur de la Fig. 13.

La Fig. 1 illustre la structure fonctionnelle d'un récepteur mobile de données qui comporte les sous-ensembles suivants:

- une antenne 1,
- un ensemble 2 des circuits HF et FI,
- un démodulateur 3,
- un circuit de mise en forme et de récupération d'horloge bit 4,
- un module de synchronisation 5,
- un démultiplexeur 6, et
- un circuit d'exploitation 7.

L'ensemble 2 reçoit le signal HF de l'antenne 1 et délivre à l'entrée du démodulateur 3 un signal FI dont le niveau est pratiquement constant. Le démodulateur 3 délivre le signal en bande de base à l'entrée du circuit 4 dont une sortie 8 délivre le train binaire et dont la sortie 9 délivre l'horloge bit du train de la sortie 8.

Dans le circuit de synchronisation 5, sont recherchés les débuts périodiques des paquets. La sortie des données 10 reliée à l'entrée du démultiplexeur 6 n'est activée que dans certaines conditions de bonne synchronisation qui seront explicitées dans la suite.

Le démultiplexeur 6 sélectionne les paquets correspondant à la source sélectionnée dans le récepteur et transmet au circuit d'exploitation 7 les octets utiles du bloc par la liaison à huit fils parallèles 11, l'information de validation d'octet INT par le fil 12 et le marquage de l'octet d'indice par le fil 13.

Dans le train binaire de la Fig. 2a, dont on a montré le paquet (n + 1) précédé du paquet n et suivi du paquet (n + 2), les débuts de paquets I surviennent périodiquement avec un périodicité de 41 x 8 bits. Chaque paquet commence par un préfixe de paquet formé de huit octets. Le préfixe de paquet est suivi d'un champ de données comprenant au maximum 32 octets, les deux derniers octets S1 et S2 du champ de données formant un suffixe ou CRC. Le champ de données est suivi d'octets de bourrage jusqu'à concurrence de 41 octets entre deux débuts I de paquet. Ainsi, quand un champ de données a la longueur maximale de 32 octets, il est toujours suivi d'un octet de bourrage 00.

Le préfixe comprend deux octets R de synchronisation de bits, un octet OC de synchronisation d'octets, trois octets X, Y et Z d'adresse de voies, un octet IC d'indice de continuité paquet et un octet SP de structure de paquet. Dans l'exemple décrit, exprimés en hexadécimal, les octets R peuvent être 55 (ou AA) et l'octet OC peut être 18 (ou E7).

Dans la suite de la description, les octets du champ de données qui précède le suffixe seront appelés bloc de données, étant entendu que le suffixe n'est constitué que par les bits de redondance d'un code cyclique de degré 16 calculés, pour chaque paquet, sur ce bloc de données. Comme dans la demande de brevet EP-A-0 077 712 mentionnée ci-dessus, les blocs de données relatifs à de l'information provenant d'une même source, définie par XYZ, sont regroupés de façon séquentielle en groupes de longueur finie, appelés groupes de données. Chaque groupe de données est composé d'un en-tête de groupe de données suivi par les données du groupe de données.

L'en-tête du groupe de données suit le préfixe du paquet transportant le premier bloc du groupe que l'on désigne plus simplement dans la suite par le "premier paquet". L'en-tête du groupe contient des informations concernant le groupe, c'est-à-dire par exemple:

- type de groupe,
- indice de continuité du groupe,
- indice de répétition du groupe,
- taille du groupe.

Dans l'exemple décrit, la répétition d'un groupe peut varier de 0 à 15.

Le module de synchronisation 5, Fig. 3, comporte un circuit de décodage de motif de synchronisation 14 ayant une entrée de données reliée à la sortie 8 du circuit de mise en forme et de récupération d'horloge bit 4, Fig. 1, et une entrée d'horloge reliée à la sortie 9 du même circuit 4. Il a une liaison 15 reliée à une unité logique de traitement 16 et une sortie 17 reliée à l'entrée d'un circuit de débrassage 18 dont la sortie est reliée à l'entrée d'un circuit de remise en phase des octets de données 19. La sortie du circuit 19 est reliée à l'entrée du démultiplexeur 6.

Le circuit de décodage de motif de synchronisation 14 peut être constitué par un registre à décalage REG et une mémoire morte programmable PROM. La capacité du registre est égale à celle du motif à rechercher, son entrée de données est reliée à l'entrée 8 et son entrée d'horloge est reliée à l'entrée 9. La sortie série du registre est reliée par une porte à la sortie 17. Les sorties parallèles du registre sont reliées aux entrées d'adresse de la mémoire morte programmable qui a plusieurs sorties d = 0, d = 1 et d = +1 qui sont reliées à la liaison 15. La sortie d = 0 est activée quand la distance de Hamming avec le motif de synchronisation est égale à 0, la sortie d = 1 est activée quand cette distance est égale à 1 et la sortie d = +1 est activée quand cette distance est supérieure à 1. De plus, la mémoire comporte une sortie DIR indiquant que le motif traité était un mot direct et une sortie INV indiquant que le motif traité était le complément du mot direct. Entre ces sorties et la liaison 15 des portes sont prévues qui sont validées à des instants prédéterminés par l'unité logique 16, à travers 15.

L'unité logique de traitement 16 comprend un microprocesseur capable d'analyser les informations émises par les sorties d = 0, d = 1 et d = +1 et de prendre quatre états E0, E1, E2 et E3 qui sont illustrés à la Fig. 4. L'unité logique 16 décide, en fonction de ces états, les instants de lecture des sorties d = 0, d = 1 et d = +1. D'autre part, elle a une sortie de commande pour valider ou non la liaison 17.

Le circuit de débrassage 18 est un circuit connu qui est nécessaire quand on a utilisé à l'émission un brassage destiné à faciliter la récupération de l'horloge bit. En effet, certaines combinaisons de données pourraient annuler l'énergie spectrale de la fréquence de récupération. Pour l'éviter, le paquet est brouillé, sauf l'en-tête, par une séquence pseudo-aléatoire, la séquence brouilleuse étant initialisée à chaque paquet. Dans le circuit 18, le débrouillage est réalisé par addition modulo-2 avec une table en mémoire morte.

Le circuit de remise en phase des octets de données 19 est un circuit qui inverse ou non la trame binaire suivant que la sortie INV ou DIR a été activée dans la mémoire PROM du circuit 14.

Dans l'état E2, le circuit de décodage recherche bit à bit le motif de synchronisation qui est constitué par la séquence de 16 bits comprenant le second octet de synchronisation bit R suivi de l'octet OC. Donc, quand l'unité logique 16 est à l'état E2, la sortie d = 0 est validée en permanence. En pratique, à l'état E2, deux motifs AAE7 ou 5518 sont recherchés car, étant donné les perturbations du signal HF reçu, la récupération de la phase du signal se fait à 180° près.

Aussitôt le motif de synchronisation ou son inverse trouvé, la sortie d = 0 est activée et cette information est transmise, par 15, au microprocesseur de l'unité logique 16 qui mémorise le résultat et passe à l'état E3. Au paquet suivant, c'est-à-dire à la distance temporelle de 41 octets, si le motif de synchronisation est de nouveau retrouvé, la sortie d = 0 est encore activée et le même signal est transmis de 14 à 16. L'unité logique 16 passe alors à l'état E0. Dans le cas contraire, elle repasse à l'état E2. En considérant les distances de Hamming, on peut dire qu'à l'état E2 la reconnaissance d'un motif de synchronisation sans erreur fait passer le système à l'état E3, qu'à l'état E3 la nouvelle reconnaissance du motif à distance d = 0 fait passer le système à l'état E0, tandis que si l'on a d différent de 0, le système repasse à l'état E2.

A l'état E0, la recherche du motif de synchronisation est validée au 25e bit suivant le début I de chaque paquet, cet instant étant déterminé par l'unité logique 16. Si, à l'état E0, le prochain motif de synchronisation trouvé est à une distance de Hamming d = 0 ou d = 1, les sorties correspondantes sont activées et l'unité logique 16 laisse le système à l'état E0.

Si, à l'état E0, le prochain motif de synchronisation est trouvé avec une distance de Hamming d supérieure à 1, la sortie d = +1 est activée et l'unité logique 16 fait passer le système à l'état E1.

A l'état E1, si le prochain motif de synchronisation, toujours cherché au 25e bit après l'instant I, est trouvé avec une distance de Hamming d = 0 ou d = 1, les sorties correspondantes sont activées et l'unité logique 16 fait repasser le système à l'état E0.

Si, à l'état E1, le prochain motif de synchronisation est trouvé avec une distance de Hamming supérieure à 1, la sortie d = +1 est activée et l'unité logique 16 fait repasser le système à l'état E2.

Le démultiplexeur 6, Fig. 3, comprend un circuit de sélection de voies ou de sources 20 dont la sortie est reliée à une interface de sortie 21. Le circuit de sélection 20 reçoit le train binaire du circuit 19 et peut être constitué, comme le circuit 14, par un registre et une mémoire programmable dont le contenu est l'identité XYZ de la voie ou source dont l'utilisateur désire exploiter les informations. Etant donné que les octets X, Y et Z d'adresse de sorce sont protégés par un codage de Hamming, comme d'une manière générale tous les octets d'en-tête, le circuit de sélection comprend également les circuits de correction nécessaires, montés en amont du registre. Quand le circuit de sélection a reconnu les octets X, Y et Z avec une distance de Hamming d égale à 0 ou à 1, il transmet à l'interface de sortie 21 les octets qui suivent l'octet Z.

L'interface de sortie 21 reçoit donc le train binaire qui est illustré à la Fig. 2b. Chaque salve de 34 x 8 bits est séparée de la suivante par un temps mort qui, pour un débit de 30 kbit/s, correspond à 1,867 ms. L'interface 21 effectue la conversion série-parallèle des octets et a un port 22 qui délivre en parallèle les bits B0 à B7 de chaque octet de données, une sortie 23 qui transmet un bit de demande d'interruption INT et une sortie 24 qui transmet un bit IC de marquage de l'octet d'indice. Donc, à chaque octet prêt, l'interface fait, par 22, une demande d'interruption INT vers le circuit d'exploitation 7. Par ailleurs, le bit IC est marqué pendant la transmission de l'octet d'indice. Ainsi, le circuit d'exploitation 7 se synchronise sur IC au début de chaque paquet et, en cas de rupture de traitement due aux erreurs, sur les octets d'en-tête de groupe du premier paquet. Donc, les circuits 5 et 6, d'une part, et 7, d'autre part, peuvent fonctionner de manière indépendante avec leurs performances propres.

Le diagramme fonctionnel de la Fig. 5 illustre le fonctionnement du module d'exploitation 7 qui est destiné à livrer des pages de données à l'utilisateur.

Dans la suite, on suppose que, utilisant la procédure DIDON 3 mentionnée plus haut pour véhiculer un magazine constitué de pages d'adresses XYZ et découpées en articles (au sens UL5 de la norme ANTIOPE), il y a correspondance biunivoque entre un groupe et un article.

Les blocs fonctionnels du circuit 7 sont une interface d'entrée 25 dont les entrées sont respectivement reliées aux liaisons 22 à 24 provenant du démultiplexeur 6. La sortie de l'interface d'entrée 25 est reliée à un ensemble de recherche de début d'article ou de groupe 26 dont la sortie est reliée à une entrée d'un ensemble de recherche de paquets sans erreur 27. La sortie du bloc 27 est reliée à un ensemble de reconstitution de groupe après les répétitions 28. Les sorties du bloc 28 sont respectivement reliées au bloc 26, au bloc 27 et à une mémoire en file 29 qui contient la liste des articles. La mémoire 29 est reliée à un ensemble de contrôle 30 de la présence de tous les articles liés constituant une page. La sortie du bloc 30 est reliée à un ensemble 31 contenant la liste des articles à fournir à une interface de ligne 32 qui délivre la page sélectionnée à l'utilisateur. L'interfacé de ligne 32 est une liaison V24 définie suivant la recommandation correspondante du CCITT.

L'ensemble 27 traite le suffixe de chaque bloc de données et rejette tous les paquets comportant des erreurs. Par contre, il transmet à 28 chaque paquet trouvé bon, lequel y est mémorisé à l'adresse définie par la valeur de l'octet IC d'indice de continuité. La sortie de 28 vers 26 sert à réinitialiser 26 à la recherche d'un début de groupe. La sortie de 28 vers 27 lui indique quelle valeur d'indice de continuité il doit prendre en compte.

En pratique, le circuit 7 reconstitue, d'une part, l'information contenue dans chaque groupe en gérant la procédure DIDON 3, c'est-à-dire vérifie la continuité et la validité des paquets reçus du démultiplexeur et gère les répétitions au niveau du groupe, et, d'autre part, reconstitue une page à partir des groupes reçus. On suppose que le circuit 7 envoie à l'utilisateur, par l'interface V24 32, chaque page reçue entièrement et correctement sous la forme des articles consécutifs de la page.

Ainsi, sur le plan de l'organisation logicielle, les tâches du circuit 7 sont au nombre de trois, à savoir:

- réception des groupes, ce qui correspond au traitement de la procédure DIDON 3, à partir de l'indice de continuité paquet,
- fonction de décision pour la reconstitution des pages qui consiste à vérifier qu'une page a été reçue complètement, et
- fonction de vidage vers la liaison V24 pour l'utilisateur.

Ces trois tâches obéissent à des règles de priorité qui sont les suivantes:

- la tâche réception doit intervenir dès qu'il y a un information prête à être transmise par 6 qui donc active l'interruption INT vers l'interface d'entrée 25,
- les tâches vérification de page et de vidage vers V24 doivent être exécutées de manière à ne pas freiner le flux de sortie. C'est donc le programme principal qui essaye de vider les octets dès qu'il y a un temps mort dans la tâche réception. Comme le montre le schéma logiciel de la Fig. 6, il y a donc trois modules: un module DIDON 3 activé sur interruption, un module UL5 organisé en programme principal et un module V24 organisé de même.

Dans le schéma logiciel de la Fig. 6, on distingue entre les modules DIDON 3, UL5 et V24 trois interfaces 33 à 35.

L'interface 35, encore montrée à la Fig. 7, est commune aux trois modules et définit la structure de la mémoire. L'unité transmissible entre les modules est l'article qui correspond donc à une portion de mémoire contiguë d'une taille égale au maximum de la taille d'un article, soit, dans l'exemple décrit, 2010 octets.

Dans l'interface 33, la structure de données décrivant, la repartition mémoire est celle de la Fig. 7, où:

- TAi est le tampon d'article numéro i, avec une taille de 2010 octets, soit 67 paquets de 30 octets,
- TETAT est le tableau décrivant la mémoire, avec (n+1) éléments de 3 octets, où:
- un octet indique si le tampon est libre ou utilisé par un module,
- deux octets donnent l'adresse du tampon,
- NETAT est un octet donnant le nombre de tampons libres, avec un maximum de 256, par exemple.

A l'initialisation, tous les tampons sont déclarés libres sauf 1, affecté aussitôt au module DIDON 3 pour recevoir le premier article, et NETAT est initialisé à n.

L'interface 34 se trouve entre le module DIDON 3 et le module UL5. L'entité manipulée y est également l'article. Les articles passent à travers une mémoire organisée en file circulaire (FiFo) de taille (n+1).

Dans l'interface 34, Fig. 8, la structure comprend les éléments suivants:

- TFIFO est un tableau de (n+1) éléments de trois octets, où:
- un octet i donne l'indice dans TETAT, Fig. 7, du tampon utilisé,
- deux octets TUi donnent la taille utile dans le tampon, 0 TUi 2000,
- IFIFO est l'indice dans TFIFO indiquant où entrer le prochain article complet,
- OFIFO est l'indice dans TFIFO indiquant le plus ancien article arrivé.

A l'initialisation, IFIFO et OFIFO sont mis à 0 pour indiquer que le premier article complet est à mettre en tête de FIFO et que la FiFo est vide.

L'interface 35, Fig. 9, est une table qui indique les portions de mémoire à émettre sur la liaison V24. Sa structure comprend les éléments suivants:

- TV24 est un tableau de n éléments de cinq octets, où:
- un octet i donne dans TETAT, Fig. 7, l'indice du tampon utilisé,

- deux octets ADi donnent l'adresse du premier octet à émettre sur la liaison V24, et

- deux octets TUi donnent le nombre exact d'octets à émettre,

- IV24 est, dans TV24, l'indice qui indique le dernier descripteur de tampon à vider.

Le module DIDON 3, Fig. 6, est activé sous INT à chaque octet présenté sur la liaison 22. Pour des raisons d'efficacité, on ne prévoit qu'une seule recopie de l'information ce qui implique de savoir à l'avance où va s'écrire l'octet dans le tampon. En pratique, un tampon d'article (ou groupe) est coupé fictivement en blocs de 30 octets, ce qui correspond à un maximum de 67 blocs.

Un descripteur de tampon est créé, indiquant pour chaque bloc si celui-ci a été reçu correctement.

Le rôle du module DIDON 3 est d'explorer les tampons d'articles en fonction de l'indice de continuité paquet et de l'indice de premier bloc, contenant l'en-tête, et de combler les trous. Afin d'être toujours disponible en réception, un tampon doit toujours être affecté au module DIDON 3.

Un article n'est passé dans la mémoire en file 34 que si, et seulement si, cet article a été reçu complètement et sans erreur, et s'il reste un tampon libre dans 34. Si l'une de ces deux conditions n'est pas réalisée à la fin de réception de l'article, le même tampon sera réutilisé, avec un descripteur remis à 0, pour la réception de l'article qui suit.

Le module UL5 est actif en alternance avec le module V24 pour déterminer si une page complète a été reçue. Les articles entrants se prennent à partir de OFIFO à la condition que OFIFO soit différent de IFIFO. Cette condition est suffisante car, étant donné la taille (n+1) de la mémoire en file 34 et le nombre maximal d'articles en entrée, soit n, le seul cas ou OFIFO = IFIFO est celui où la mémoire en file est vide.

Le module UL5 est actif jusqu'à avoir déterminé qu'une page a été reçue entièrement. Dans ce cas, il y a construction de la table TV24 et passage au module V24 de vidage en ligne.

Quand le module V24 est activé, c'est qu'une page a été reçue entièrement. Il s'agit alors de vider les IV24 entrées de la table TV24. A chaque fois qu'un tampon est vidé, son état dans TETAT est remis à libre.

L'initialisation du logiciel est confiée au module UL5 pour remplir TETAT et NETAT, et pour initialiser DIDON 3.

La Fig. 10 montre le bloc-diagramme de l'ensemble 2 des parties HF et FI du récepteur. Elles comprennent, montés en série, entre l'entrée 36 reliée à l'antenne 1, et la sortie 37 reliée au démodulateur 3, un atténuateur d'entrée 38, un filtre passe-bande 39, un amplificateur HF 40, un atténuateur variable 41, un filtre passebande 42, un autre amplificateur HF 43, un premier mélangeur 44, un filtre passe-bande 45, un amplificateur FI 46, un second atténuateur variable 47, un second amplificateur FI 48, un filtre passe-bande 49, un second mélangeur 50 et un amplificateur FI 51.

Le premier mélangeur 44 a une seconde entrée reliée à la sortie d'un premier oscillateur local 52 par un amplificateur 53. Le second mélangeur 50 a une seconde entrée reliée à un second oscillateur local 54.

L'amplificateur 48 a une seconde sortie qui est reliée au circuit générateur 55 des tensions de contrôle automatique de gain. Dans le circuit 55, la sortie de 48 est reliée à l'entrée d'un filtre à quartz 56 dont la sortie est reliée à un amplificateur accordé 57 dont la sortie est reliée à un circuit de détection de crête 58. La sortie du circuit de détection de crête 58 est reliée, d'une part, à un premier générateur de tension 59 dont la sortie est reliée à l'entrée de commande de l'atténuateur variable 47 et, d'autre part, à un second générateur de tension 60 dont la sortie est reliée à l'entrée de commande de l'atténuateur de tension 41. Les générateurs 59 et 60 ont respectivement des entrées de tensions de référence réglables 61 et 62 provenant d'un circuit 63.

La structure de l'ensemble 2 de la Fig. 10 qui vient d'être décrite est tout à fait classique. A l'entrée 36, la fréquence HF peut être de 67,75 MHz, par exemple; à la sortie du premier mélangeur 44, la première fréquence intermédiaire peut être de 10,7 MHz; et à la sortie du second mélangeur 50, la seconde fréquence intermédiaire peut être de 275 kHz.

Suivant l'invention, les générateurs 59 et 60 ont été conçus pour tenir compte du fait que le récepteur est mobile et est destiné à recevoir des données numériques.

A la Fig. 11, on a représenté le schéma détaillé des générateurs 59 et 60 et du circuit 63 du circuit de contrôle automatique de gain 55.

Le circuit 63 se compose de trois diviseurs de tension, montés entre une source de tension de +24 V et la masse, et comprenant respectivement un potentiomètre P1 en série avec une résistance R1, un potentiomètre P2 en série avec une résistance R2, et un potentiomètre P3 en série avec une résistance R3. Le curseur du potentiomètre P1 est relié à l'entrée de tension de polarisation du détecteur de crête 58 et permet d'effectuer classiquement le centrage du contrôle automatique de gain.

Le générateur 59 se compose d'un amplificateur opérationnel 64, par exemple du type commercialisé sours la référence LF 13741, dont l'entrée inverseuse est reliée à la sortie du détecteur de crête 58 par une résistance R4, dont l'entrée non inverseuse est reliée par une résistance R5 au curseur du potentiomètre P2, et dont la sortie est reliée à l'entrée de commande de l'atténuateur FI 47.

De même, le générateur 60 se compose d'un amplificateur opérationnel 65, du même type que 64, dont l'entrée inverseuse est reliée à la sortie du détecteur de crête 58 par deux résistances R6 et R7 en série, dont l'entrée non inverseuse est reliée par une résistance R8 au curseur du potentiomètre P3, et dont la sortie est reliée à l'entrée de commande de l'atténuateur HF 41. Le point commun aux résistances R6 et R7 est relié à la masse par une résistance R9.

Dans chacun des amplificateurs opérationnels 64 et 65, la sortie est également reliée à l'entrée inverseuse par un condensateur et une résistance en parallèle.

Il est connu que, dans les récepteurs radiofréquences classiques, on prévoit généralement deux commandes automatiques de gain, l'une, agissant en FI, possédant une grande dynamique et l'autre, agissant en HF, n'intervenant que pour des niveaux élevés à l'entrée du récepteur, le protégeant ainsi des risques d'intermodulation.

Dans le cas de réception mobile de données en bande I, l'antenne placée sur le véhicule a un gain voisin de 0 dB, et le niveau des parasites industriels est élevé et souvent supérieur de 15 à 20 dB au signal utile. Donc, la commande automatique de gain a, suivant l'invention, pour objet de protéger au mieux les étages d'amplification des risques d'intermodulation dus aux signaux parasites. En diffusion de données, la dégradation du taux d'erreurs n'est sensible que pour E/No inférieur à 12 dB. On peut donc atténuer le signal dès les premiers étages sans modification des performances du récepteur.

Les réglages des curseurs des potentiomètres P2 et P3 permettent de décaler le seuil de 64 par rapport à celui de 65, ce qui revient à différer la CAG HF par rapport à la CAC FI. Le montage à l'entrée inverseuse de l'amplificateur 65 permet de diminuer la constante de temps de l'amplificateur 65 par rapport à celle de l'amplificateur 64. Autrement dit, on choisit pour la CAC HF une constante de temps par exemple cinq fois inférieure à celle de la CAG FI. Il en résulte que la CAG HF, quand elle agit, le fait très rapidement.

En fonctionnement, pour une variation lente à l'entrée 36, les CAG FI et HF s'équilibrent. Pour des variations rapides, la CAG FI s'aligne sur la valeur moyenne du signal, la CAG HF agissant sur les variations rapides de niveau, ce qui permet d'adapter le point de fonctionnement optimal des étages d'entrée, assurant la meilleure protection contre les parasites industriels.

La Fig. 12 montre le bloc-diagramme détaillé du démodulateur 3 qui reçoit à son entrée 37 le signal de seconde fréquence intermédiaire à 275 kHz et délivre à sa sortie 66 le signal démodulé au circuit de mise en forme et de restauration d'horloge bit 4.

L'entrée 37 est reliée à un amplificateur 67 dont la sortie est reliée à un filtre de bande 68 dont la sortie est reliée à un circuit de mise en forme rectangulaire 69. La sortie du circuit de mise en forme rectangulaire 69 est reliée, d'une part, à la première entrée d'un comparateur de phase 70 et, d'autre part, à une première entrée d'un multiplicateur 71. La sortie du comparateur de phase 70 est reliée à l'entrée d'un intégrateur 72 dont la sortie est reliée à l'entrée de commande d'un oscillateur 73 à commande par la tension ou oscillateur VCO. La sortie de l'oscillateur VCO 73 est reliée, d'une part, à la seconde entrée du comparateur de phase 70 et, d'autre part, à l'entrée d'un déphaseur 74 dont la sortie est reliée à l'entrée d'un diviseur de fréquence par deux 75 dont la sortie est reliée à la seconde entrée du multiplicateur 71. La sortie du multiplicateur 71 délivre le signal démodulé.

Le démodulateur de la Fig. 12 est plus spécialement conçu pour assurer la restitution de signaux numériques codés en NRZ à partir d'une porteuse modulée en MSK centrée à 272,8 kHz. La démodulation cohérente nécessite la régénération du signal de référence cos $F_1t$. On l'obtient à partir de l'oscillateur VCO 73 qui fonctionne à la fréquence $2F_1$. La boucle d'asservissement de l'oscillateur VCO comprend le comparateur de phase 70 qui fonctionne à $2F_1$, ce qui élimine l'information de phase. La démodulation proprement dite du signal modulé est effectuée par le multiplicateur 71 qui reçoit le signal modulé mis en forme et la porteuse $F_1$ obtenue par division par deux du signal de sortie de l'oscillateur VCO. Le déphaseur ou circuit à retard réglable 74 sert à ajuster les phases aux entrées du multiplicateur.

Il apparaît donc que le démodulateur de la Fig. 12 n'introduit pas, comme dans les démodulateurs classiques, de multiplicateurs analogiques qui, en présence de bruit, perdent en partie leur efficacité. De plus, aux fréquences utilisées dans l'exemple de réalisation en modulation MSK, soit avec un débit de 30 kbit/s, la technologie classique serait lourde à mettre en oeuvre.

Il est bien évident qu'au lieu de la modulation MSK on peut utiliser une modulation analogue, telle que la modulation "Tamed Frequency Modulation" ou TFM, ou encore une modulation à codage à réponse partielle.

A la Fig. 13, on a représenté un schéma détaillé des circuits 69 à 75 de la Fig. 12. Le circuit de mise en forme rectangulaire 69 est concrétisé par un circuit de référence commerciale 4093, l'oscillateur VCO 73 par un circuit 2209, le comparateur de phase 70 par une bascule 4013, le circuit de déphasage réglable par un circuit 4528, le diviseur de fréquence par deux par une bascule 4013, et le démodulateur 71 par une bascule 4013.

Le circuit 69 a sa borne 2* reliée à la sortie du filtre 68 et sa borne 3* respectivement reliée aux bornes C1 et DATA des bascules 70 et 71. La borne 1* de 69 est reliée à un circuit définissant sa constante de temps. Il délivre des signaux rectangulaires MSK.

L'entrée DATA de la bascule 70 est reliée à la sortie d'un circuit de mise en forme rectangulaire 76 dont l'entrée est reliée à la sortie 7* de l'oscillateur 73. Les signaux de la sortie Q de la bascule 70 sont intégrés dans un intégrateur comprenant classiquement un condensateur C1 et des résistances R10 et R11. La sortie de l'intégrateur 72 est reliée à la borne 4* de l'oscillateur dont les bornes 1*, 2*, 3*, 5*, 6* sont reliées d'une manière connue à des combinaisons de composants passifs déterminant sa fréquence centrale de fonctionnement.

Le circuit 74 a sa borne 4* reliée à la borne 3* du circuit 76, ses bornes 1* et 2* reliées à un réseau de composants passifs, dont un potentiomètre permettant d'ajuster son retard, et sa borne 7* reliée à l'entrée C1 du diviseur 75 dont les bornes 2* et 5* sont reliées ensemble, les bornes 4*, 6*, 7* sont à la masse, et la sortie Q est reliée à l'entrée C1 du démodulateur 71. La sortie Q de 71 délivre le signal démodulé.

Le fonctionnement du comparateur 70 est illustré par les formes d'onde de la Fig. 14a, où la forme d'onde de la Fig. 14a.1 représente le signal de fréquence $2F_1$ appliqué à l'entrée de données DATA de la bascule 70, la Fig. 14a.2 représente le signal modulant appliqué à l'entrée d'horloge C1 de 70, et la Fig. 14a.3 le signal à sa sortie Q.

Il apparaît que le signal modulant à l'entrée d'horloge permet de voir à la sortie Q l'état de l'entrée DATA. A décalage constant, l'inversion de phase n'agit pas sur la sortie Q, comme l'illustre la Fig. 14a. Le comparateur est donc insensible au sauts de phase 0-180° et ne prend en compte que le décalage de phase statique.

Le fonctionnement du multiplicateur 71 est illustré par les formes d'onde de la Fig. 14b, où la Fig. 14b.1 représente le signal appliqué à l'entrée d'horloge C1 de la bascule 71, la Fig. 14b.2 représente le signal modulant appliqué à son entrée DATA et la Fig. 14b.3 le signal délivré par la sortie Q et qui constitue le signal démodulé.

**Revendications**

1. Méthode de radiodiffusion de paquets de données binaires pouvant être reçus dans des récepteurs mobiles, dans laquelle les débuts des paquets sont émis périodiquement, le préfixe de chaque paquet commençant par deux octets de synchronisation de bits et un octet de synchronisation d'octets, le second octet de synchronisation de bits et l'octet de synchronisation d'octets constituant un motif de synchronisation périodique de début de paquet, caractérisée en ce que le traitement de la synchronisation comprend une phase de recherche et une phase de poursuite, le passage de la phase de recherche à la phase de poursuite étant effectué quand, en phase de recherche, le motif de synchronisation a été trouvé deux fois consécutives avec distance de Hamming nulle, la phase de recherche comportant au moins deux états, le passage du premier (E2) au second (E3) étant effectué quand un motif de synchronisation a été trouvé avec distance de Hamming nulle, le passage du second (E3) au premier (E2) étant effectué quand le motif suivant n'est pas trouvé avec une distance de Hamming nulle, la phase de poursuite comprenant également au moins deux états, le premier (E0) étant l'état pris après le passage de la phase de recherche à la phase de poursuite, le passage du premier (E0) au second (E1) quand le motif suivant est trouvé avec une distance de Hamming supérieure à 1, le passage du second (E1) au premier (E0) étant effectué quand le motif suivant est trouvé avec une distance de Hamming nulle ou égale à 1, le passage de la phase de poursuite à la phase de recherche étant effectué quand, dans le second état de la phase de poursuite, le motif suivant est trouvé avec une distance de Hamming supérieure à 1.

2. Méthode suivant la revendication 1, dans laquelle la modulation utilisée est une modulation de phase à deux états et à bande latérale atténuée, caractérisée en ce que, dans la phase de recherche, la détection du motif de synchronisation est également effectuée sur son complément, les états de recherche et de poursuite étant dédoublés en états directs et complémentés respectivement, en premier état de recherche la reconnaissance du motif direct inhibant les états complémentés et vice-versa.

3. Méthode suivant la revendication 1 ou 2, dans laquelle les données binaires provenant d'une source sont associées en groupes qui sont découpés pour former une séquence de blocs de données, chaque bloc complété par un suffixe de contrôle constituant le champ de données d'un paquet, l'émission de chaque groupe étant répétée un certain nombre de fois, caractérisée en ce que les groupes sont reconstitués à la réception au fur et à mesure des répétitions des groupes, puis en ce que les groupes sont assemblés en page au fur et à mesure qu'un groupe complet, sans erreur, a été reçu.

4. Méthode suivant l'une des revendications 1 à 3, dans laquelle sont prévues une première commande automatique de gain agissant dans l'étage HF et une seconde commande automatique de gain agissant dans l'étage FI, caractérisée en ce que la constante de temps de la première commande automatique de gain est sensiblement inférieure à celle de la seconde commande automatique de gain.

5. Méthode suivant l'une des revendications 1 à 4, dans laquelle les données binaires sont transmises en modulation MSK ou analogue, caractérisée en ce qu'à la réception, le signal modulé est mis en forme rectangulaire, puis comparé en phase avec un signal de référence rectangulaire de fréquence réglable double de la fréquence porteuse du signal modulé, l'écart de phase constaté à la comparaison servant à régler la fréquence du signal de référence, la fréquence du signal de référence étant divisée par deux pour fournir un signal qui est multiplié avec le signal modulé pour produire le signal démodulé.

6. Moyens de réception de données binaires transmises selon une méthode de radiodiffusion suivant l'une des revendications 1 à 5, les moyens de réception comprenant en série une antenne (1), des circuits HF et IF (2), un démodulateur (3), un circuit de mise en forme et de récupération d'horloge bit (4), un module de synchronisation de paquets (5), un démultiplexeur (6) et un circuit d'exploitation (7), caractérisés en ce que le module de synchronisation (5) comprend un décodeur de motif de synchronisation (14) délivrant les signaux (d=0, d=1, d= +1, DIR et INV) indiquant respectivement quand le motif est trouvé avec une distance de Hamming nulle, égale à 1 ou plus grande que 1 et quand le motif est trouvé direct ou inversé, les sorties dudit décodeur de motif de synchronisation (14) étant reliées à une unité logique de traitement (16) qui traduit les signaux délivrés en données d'état de phase de recherche ou de poursuite, une sortie de l'unité logique de traitement (16) servant à valider la transmission aval des données binaires reçues.

7. Moyens de réception suivant la revendication 6, caractérisés en ce que le démultiplexeur (6) comprend un circuit de sélection de source (20) et une interface de sortie (21) et en ce que le circuit d'exploitation (7) comprend une interface d'entrée (25), des moyens de reconnaissance de début de groupe de données (26), des moyens de détection de paquets de données sans erreur (27), des moyens d'assemblage de groupe reconstitué (28), une mémoire de groupes reconstitués (29), des moyens de vérification d'assemblage de groupe reconstitué et une interface de sortie (32), les moyens d'assemblage de groupe reconstitué (28) ayant une sortie de commande vers les moyens de reconnaissance de début de groupe (26) et une sortie vers les moyens de détection de paquets de données sans erreur (27).

8. Moyens de réception suivant l'une des revendications 6 ou 7, dans lesquels les circuits HF et FI comprennent un premier et un second mélangeurs (44 et 50) respectivement précédés d'un premier et second atténuateurs (41 et 47), la sortie du second atténuateur étant reliée à un circuit de détection de crête (58) dont la sortie est reliée à un premier générateur de tension (59) et à un second générateur de tension (60), caractérisés en ce que les premier et second générateurs de tension (59 et 60) se composent d'amplificateurs opérationnels (64 et 65) dont les entrées inverseuses sont reliées à la sortie du détecteur de crête (58) par des résistances de valeurs différentes et dont les entrées non inverseuses sont polarisées différemment de manière que la constante de temps de montage de l'amplificateur (64) soit nettement supérieure à celle du montage de l'amplificateur (65), les sorties des premier et second amplificateurs (64 et 65) étant respectivement reliées aux entrées de commande des premier et second atténuateurs (41 et 47).

9. Moyens de réception suivant l'une des revendications 6 à 8, caractérisés en ce qu'ils comprennent un circuit de mise en forme rectangulaire (69) à l'entrée duquel est appliqué le signal à fréquence intermédiaire et dont la sortie est reliée, d'une part, à la première entrée d'un comparateur de phase (70) et, d'autre part, à la première entrée d'un multiplicateur (71), la sortie du comparateur de phase (70) étant reliée à l'entrée d'un circuit intégrateur (72) dont la sortie est reliée à l'entrée de commande d'un oscillateur à commande par la tension ou VCO (73) de fréquence centrale égale au double de celle du signal modulé, la sortie de l'oscillateur (73) étant reliée, d'une part, à la seconde entrée du comparateur de phase (70) et, d'autre part, à un diviseur de fréquence par deux (75) dont la sortie est reliée à la seconde entrée du multiplicateur (71) dont la sortie délivre le signal démodulé.

**Patentansprüche**

1. Datenfunksystem zum Funken von binären Datenpaketen, insbesondere zu mobilen Stationen, wobei der Beginn der Pakete periodisch gesendet wird und das Vorbereitungszeichen jedes Paketes mit Zwei-Bit-Synchronisations-Bytes und einem Byte-Synchronisations-Byte beginnt, wobei das zweite Bit-Synchronisations-Byte und das Byte-Synchronisations-Byte den Beginn eines periodischen Paket-Synchronisations-Musters bilden, dadurch gekennzeichnet, daß das Synchronisierungsverfahren eine Suchphase und eine Nachfolgephase hat, daß der Übergang von der Suchphase zu der Nachfolgephase ausgeführt wird, wenn während der Suchphase das Synchronisationsmuster zwei aufeinanderfolgene Zeiten gefunden hat mit einer Hamming-Distanz von Null, daß die Suchphase wenigstens zwei Zustände umfaßt, wobei der Übergang vom ersten Zustand (E2) zum zweiten (E3) ausgeführt wird, wenn ein Synchronisierungsmuster gefunden worden ist mit einer Hamming-Distanz von Null, während der Übergang vom zweiten Zustand (E3) auf den ersten Zustand (E2) ausgeführt wird, wenn das nächste Muster nicht mit einer Hamming-Distanz von Null gefunden worden ist, daß ferner die Nachfolgephase ebenfalls wenigstens zwei Zustände umfaßt, wobei der erste (E0) der Zustand ist, der nach dem Übergang von der Suchphase in die Nachfolgephase eingenommen wird, und der Übergang vom ersten Zustand (E0) in den zweiten (E1) ausgeführt wird, wenn das nächste Muster mit einer Hamming-Distanz größer als 1 gefunden wird, während der Übergang vom zweiten Zustand (E1) zum ersten (E0) ausgeführt wird, wenn das nächste Muster mit einer Hamming-Distanz gefunden wird, die entweder Null oder gleich 1 ist, und daß der Übergang von der Nachfolgephase in die Suchphase ausgeführt wird während des zweiten Zustandes der Nachfolgephase, wenn das nächste Muster mit einer Hamming-Distanz größer als 1 gefunden wird.

2. Datenfunksystem nach Anspruch 1, wobei die Modulation eine Zwei-Zustands-Phasenmodulation mit gedämpften Seitenbändern ist, dadurch gekennzeichnet, daß während der Suchphase die Erfassung des Synchronisierungs-Musters auch auf das Komplement des Synchronisierungsmusters ausgeführt wird und daß der Such- und der Nachfolgezustand in direkte und komplementäre Zustände entsprechend getrennt werden, wobei im ersten Such-Zustand die Erkennung des direkten Musters die Komplementärzustände sperrt und umgekehrt.

3. Datenfunksystem nach Anspruch 1 oder 2, wobei die binären Daten, die von einer Quelle stammen, in Gruppen zusammengefaßt werden, die in Segmente unterteilt werden, um eine Folge von Datenblocks zu bilden, wobei jeder Block vervollständigt wird durch ein Steuer-Suffix, welches das Datenfeld eines Paketes darstellt, wobei die Sendung jeder Gruppe eine bestimmte Anzahl von Malen wiederholt wird, dadurch gekennzeichnet, daß die Gruppen in der Empfangsstation wieder gebildet werden so schnell wie die Gruppen wiederholt werden, und daß ferner die Gruppen auf der Seite zusammengefaßt werden, sobald eine vollständige fehlerfreie Gruppe empfangen worden ist.

4. Datenfunksystem nach einem der Ansprüche 1 - 3, wobei eine erste automatische Verstärkungssteuerung vorgesehen ist, die in der HF-Stufe arbeitet, sowie eine zweite automatische Verstärkungssteuerung, die in der ZF-Stufe arbeitet, dadurch gekennzeichnet, daß die Zeitkonstante der ersten automatischen Verstärkungssteuerung beträchtlich kleiner ist als diejenige der zweiten automatischen Verstärkungssteuerung.

5. Datenfunksystem nach einem der Ansprüche 1 - 4, wobei die binären Daten mittels MSK-Modulation oder einer ähnlichen Methode gesendet werden, dadurch gekennzeichnet, daß im Empfänger die modulierten Datensignale in Rechteckwellen-Impulsform geformt werden, daß dann ihre Phase mit einem Rechteckwellen-Bezugssignal verglichen wird, das eine einstellbare Frequenz hat, die das zweifache der Trägerfrequenz des modulierten Signales ist, und daß die Veränderung der Phase, die beim Vergleich aufgezeichnet worden ist, dazu dient, die Frequenz des Bezugssignales einzustellen, und daß die Frequenz des Bezugssignals durch Zwei geteilt wird, um ein Signal zu erzeugen, das mit dem modulierten Signal multipliziert wird, um das demodulierte Signal zu erzeugen.

6. Empfangssystem zum Empfang binärer Daten, die durch ein Datenfunksystem nach einem der Ansprüche 1 - 5 gesendet worden sind, mit, in Reihe, einer Antenne (1), HF- und ZF-Schaltungen (2), einem Demodulator (3), einer Schaltung (4) zum Formen und Wiedergewinnen eines Takt-Bits, einem Paket-Synchronisierungs-Modul (5), einem Demultiplexer (6) und einem Daten-Extraktionskreis (7), dadurch gekennzeichnet, daß das Synchronisierungsmodul (5) besteht aus einem Synchronisierungs-Muster-Dekoder (14), der die Signale (d=0, d=1, d=+1, DIR und INV) erzeugt, die entsprechend anzeigen, wenn das Muster mit einer Hamming-Distanz von Null, gleich 1 oder größer als 1 gefunden wird, und wenn das Muster direkt oder invertiert festgestellt wird, daß ferner die Ausgänge des Synchronisierungs-Muster-Dekoders (14) an eine logische Prozessoreinheit (16) gelegt werden, welche die erzeugten Signale in Such- oder Nachfolge-Phasenzustandsdaten umformt, wobei ein Ausgang der logischen Prozessoreinheit (16) dazu dient, die stromabwärtige Aussendung der empfangenen binären Daten gültig zu machen.

7. Empfangssystem nach Anspruch 6, dadurch gekennzeichnet, daß der Demultiplexer (6) aus einem Quellenauswahlkreis (20) und einem Ausgangsgerät (21) besteht, daß der Datenextraktionskreis (7) besteht aus einem Eingangsgerät (25), Untersystemen zum Erkennen des Beginns von Datengruppen (26), Untersystemen zum Erfassen fehlerfreier Datenpakete (27), Untersystemen für wiedergebildete Gruppenzusammenfassung (28), einen Speicher für wiedergebildete Gruppen (29), Untersystemen zum Verifizieren der Zusammenfassung der wiedergebildeten Gruppen und ein Ausgangsgerät (32), wobei die Untersysteme für die Zusammenfassung der wiedergebildeten Gruppen (28) einen Steuerausgang für den Beginn der Gruppenerkennungsuntersysteme (26) und einen Ausgang zu den Untersystemen (27) für die Erfassung fehlerfreier Datenpakete haben.

8. Empfangsystem nach Anspruch 6 oder 7, wobei die HF- und ZF-Kreise aus einem ersten und einem zweiten Mischer (44, 50) bestehen, denen entsprechend ein erstes und ein zweites Dämpfungsglied (41, 47) vorgeschaltet ist, wobei der Ausgang des zweiten Dämpfungsgliedes an einen Spitzen-Detektorkreis (58) geschaltet ist, dessen Ausgang an einen ersten Spannungsgenerator (59) und an einen zweiten Spannungsgenerator (60) gelegt ist, dadurch gekennzeichnet, daß der erste und der zweite Spannungsgenerator (59, 60) aus Operationsverstärkern (64, 65) gebildet sind, deren invertierende Eingänge über Widerstände unterschiedlicher Größen an den Ausgang des Spitzen-Detektors (58) gelegt sind, und deren nicht-invertierende Eingänge unterschiedlich polarisiert sind, so daß die Zeitkonstante für den Aufbau des Verstärkers (64) beachtlich größer ist als diejenige für den Aufbau des Verstärkers (65), und daß die Ausgänge der beiden Verstärker (64, 65) entsprechend an die Steuereingänge der beiden Dämpfungsglieder (41, 47) geschaltet sind.

9. Empfangssystem nach einem der Ansprüche 6 bis 8, dadurch gekennzeichnet, daß es besteht aus einem Rechteckwellen-Formkreis (69), an dessen Eingang das Zwischenfrequenzsignal gelegt ist und dessen Ausgang einerseits an den ersten Eingang eines Phasenvergleichers (70) und andererseits an den ersten Eingang einer Multiplizierschaltung (71) gelegt ist, daß der Ausgang des Phasenvergleichers (70) an den Eingang eines Integratorkreises (72) gelegt ist, dessen Ausgang mit dem Steuereingang eines Spannungs-Steueroszillators oder VCO (73) verbunden ist, der eine Mittelfrequenz gleich dem zweifachen von derjenigen des modulierten Signales hat, daß der Ausgang des Oszillators (73) einerseits an den zweiten Eingang des Phasenvergleichers (70) und andererseits an einen durch Zwei teilenden Frequenzteiler (75) geschaltet ist, dessen Ausgang mit dem zweiten Eingang der Multiplizierschaltung (71) verbunden ist, deren Ausgang das demodulierte Signal erzeugt.

## Claims

1. Process for broadcasting binary data packets which can be received in mobile receivers, in which the starts of packets are transmitted periodically, the prefix of each packet starting with two bit synchronisation bytes and one byte synchronisation byte, the second bit synchronisation byte and the byte synchronisation byte constituting a start of a packet periodic synchronisation pattern, said process being characterised in that the synchronisation processing comprises a seeking phase and a tracking phase, transition from the seeking phase to the tracking phase being effected when, during the seeking phase, the synchronisation pattern has been found two consecutive times with a zero Hamming distance, the seeking phase comprising at least two states, the transition from the first state (E2) to the second (E3) being effected when a synchronisation pattern has been found with a zero Hamming distance, the transition from the second state (E3) to the first (E2) being effected when the next pattern is not found with a zero Hamming distance, the tracking phase also comprising at least two states, the first (E0) being the state taken after the transition from the seeking phase to the tracing phase, the transition from the first state (E0) to the second (E1) being effected when the next pattern is found with a Hamming distance greater than 1, the transition from the second state (E1) to the first (E0) being effected when the next pattern is found with a Hamming distance which is either zero or equal to 1, the transition from the tracking phase to the seeking phase being effected during the second state of the tracking phase when the next pattern is found with a Hamming distance greater than 1.

2. Process in accordance with claim 1, in which the modulation used is a two state phase modulation with attenuated sidebands, characterised in that, during the seeking phase, the detection of the synchronisation pattern is also carried out on the complement of the synchronisation pattern, the seeking and tracking states being separated into direct and complemented states respectively, in the first seeking state the recognition of the direct pattern inhibiting the complemented states and vice versa.

3. Process in accordance with claim 1 or 2, in which the binary data originating from one source are assembled into groups which are segmented to form a sequence of data blocks, each block being completed by a control suffix constituting the data field of a packet, the transmission of each group being repeated a certain number of times, characterised in that the groups are reconstituted at the receiver as fast as the groups are repeated, and also in that the groups are assembled on the page as soon as a complete error-free group has been received.

4. Process in accordance with one of the claims 1 to 3, which provides for a first automatic gain control acting in the HF stage, and a second automatic gain control acting in the IF stade, characterised in that the time constant of the first automatic gain control is considerably less than that of the second automatic gain control.

5. Process in accordance with one of the claims 1 to 4, in which the binary data are transmitted by using MSK modulation or similar characterised in that at the receiver, the modulated data signals are shaped into square-wave pulse form, then phase compared with a square-wave reference signal having an adjustable frequency which is twice the carrier frequency of the modulated signal, the variation of phase recorded upon comparison serving to adjust the frequency of the reference signal, the frequency of the reference signal being divided by two to provide a signal which is multiplied with the modulated signal to produce the demodulated signal.

6. Systems for receiving binary data transmitted in accordance with a broadcasting system in accordance with one of the claims 1 to 5, the receiver systems comprising in series an aerial (1), HF and IF circuits (2), a demodulator (3) a shaping and bit clock recovery circuit (4) a packet synchronisation module (5) a demultiplexer (6) and a data extraction circuit (7), characterised in that the synchronisation module (5) consists of a synchronisation pattern decoder (14) generating the signals (d=0, d=1, d=+1, DIR and INV) indicating respectively when the pattern is found with a Hamming distance of zero, equal to 1 or greater than 1 and when the pattern is found direct or inverted, the outputs of the said synchronisation pattern decoder (14) being connected to a logic processing unit (16) which translates the generated signals into seeking or tracking phase state data, an output from the logic processing unit (16) serving to validate the downstream transmission of the binary data received.

7. Receiver systems in accordance with claim 6, characterised in that the demultiplexer (6) consists of a source selection circuit (20) and an output interface (21) and in that the data extraction circuit (7) consists of an input interface (25), subsystems for recognising starts of data groups (26), subsystems for detecting error-free data packets (27), subsystems for reconstituted group assembly (28), a memory of reconstituted groups (29), subsystems for verifying reconstituted group assembly and an output interface (32), subsystems of reconstituted group assembly (28) having a control output to the start of group recognition subsystems (26) and an output to the error-free data packet detection subsystems (27).

8. Receiver systems in accordance with one of the claims 6 or 7 in which the HF and IF circuits consist of a first and second mixer (44 and 50) respectively preceded by a first and second attenuator (41 and 47), the output of the second attenuator being connected to a peak detection circuit (58) whose output is connected to a first voltage generator (59) and to a second voltage generator (60) characterised in that the first and second voltage generators (59 and 60) are made up of operational amplifiers (64 and 65) whose inverting inputs are connected to the output of the peak detector (58) by resistances of various values and whose non-inverting inputs are differently polarised so that the time constant of amplifier set-up (64) is distinctly greater than that of amplifier set-up (65), the outputs of the first and second amplifiers (64 and 65) being connected respectively to the control inputs of the first and second attenuators (41 and 47).

9. Receiver systems in accordance with one of the claims 6 to 8, characterised in that they consist of a square-wave shaping circuit (69) at the input of which the intermediate frequency signal is applied and whose output is connected on the one hand to the first input of a phase comparator (70) and, on the other hand, to the first input of a multiplier (71) the output of the phase comparator (70) being connected to the input of an integrator circuit (72) whose output is connected to the control input of a voltage control oscillator or VCO (73) of central frequency equal to twice that of the modulated signal, the output of oscillator (73) being connected on the one hand to the second input of the phase comparator (70) and, on the other hand, to a divide by two frequency divider (75) whose output is connected to the second input of multiplier (71) whose output generates the demodulated signal.

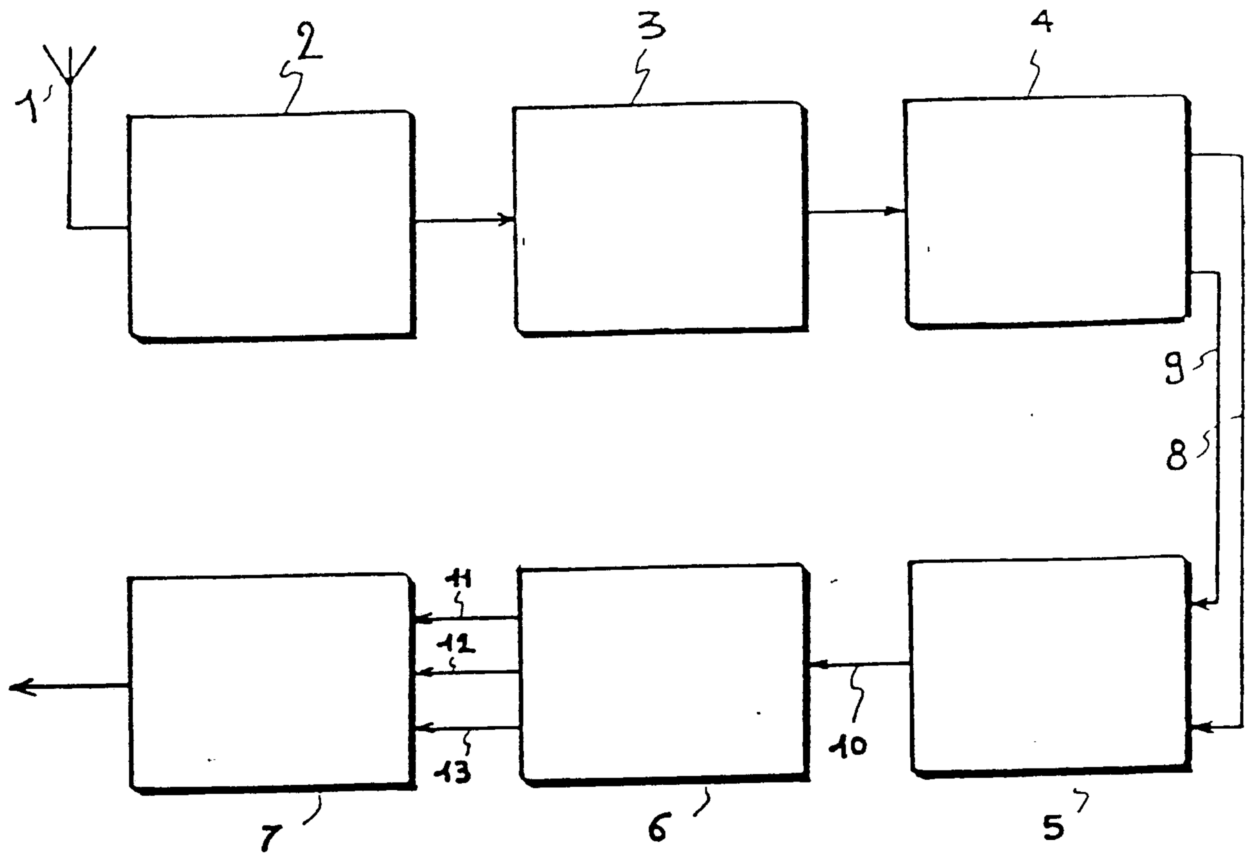


FIG.1

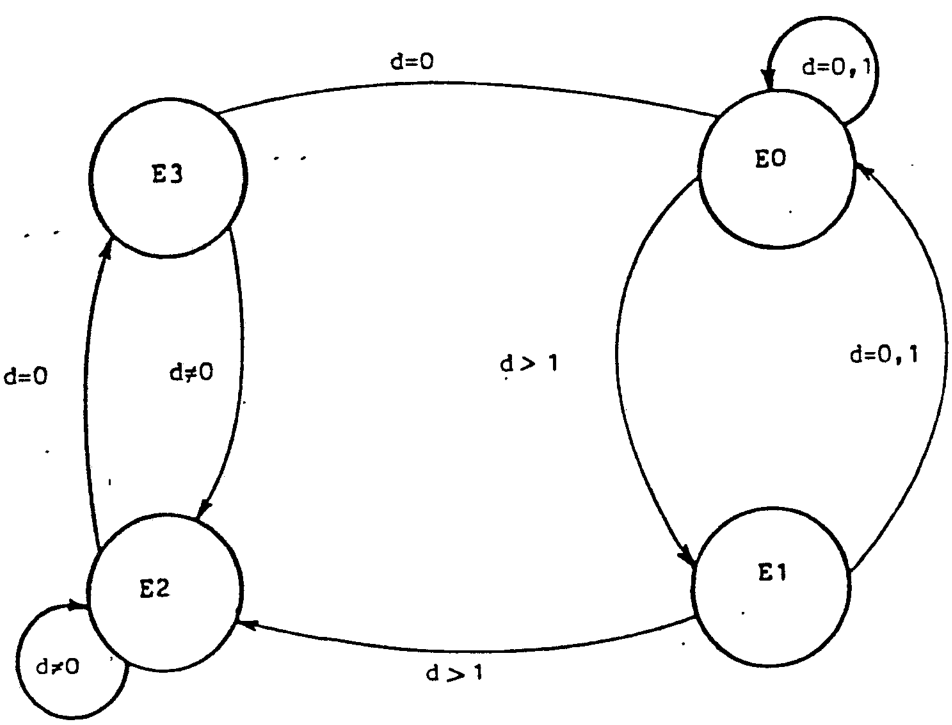


FIG. 4

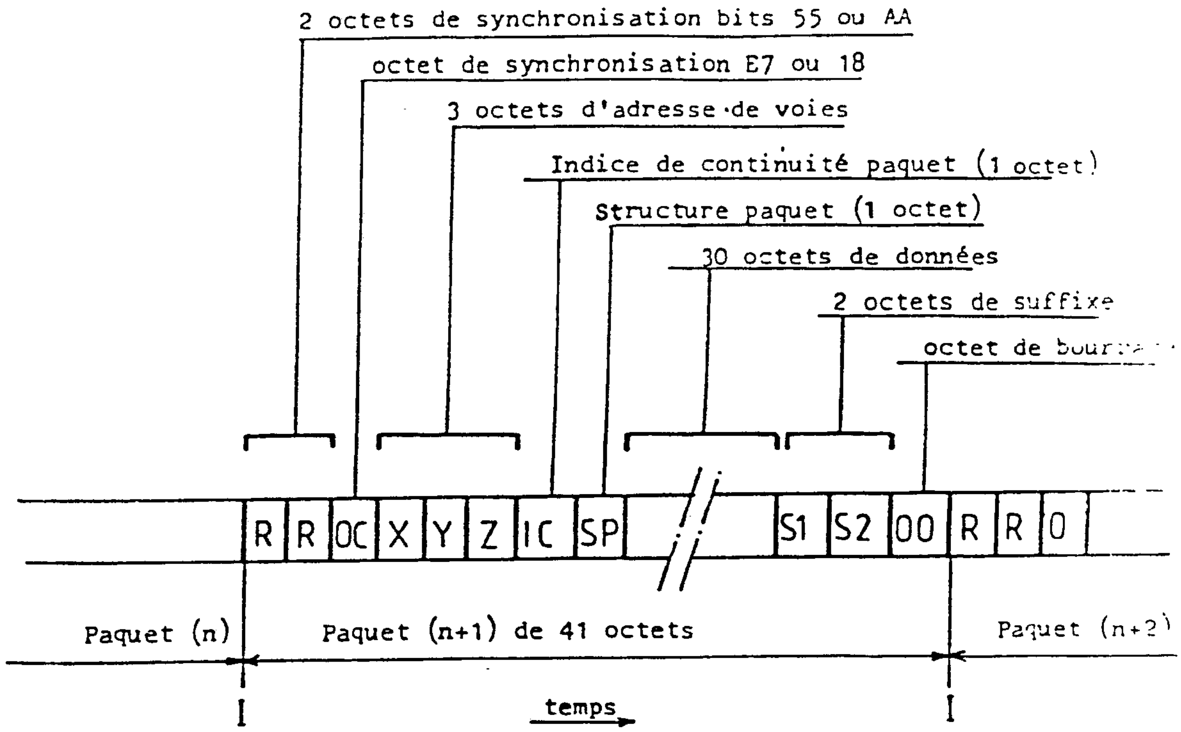
2 octets de synchronisation bits 55 ou AA
octet de synchronisation E7 ou 18
3 octets d'adresse de voies
Indice de continuité paquet (1 octet)
Structure paquet (1 octet)
30 octets de données
2 octets de suffixe
octet de
R
R
OC
X
Y
Z
IC
SP
S1
S2
00
R
R
0
Paquet (n)
Paquet (n+1) de 41 octets
Paquet (n+2)
temps

FIG. 2a

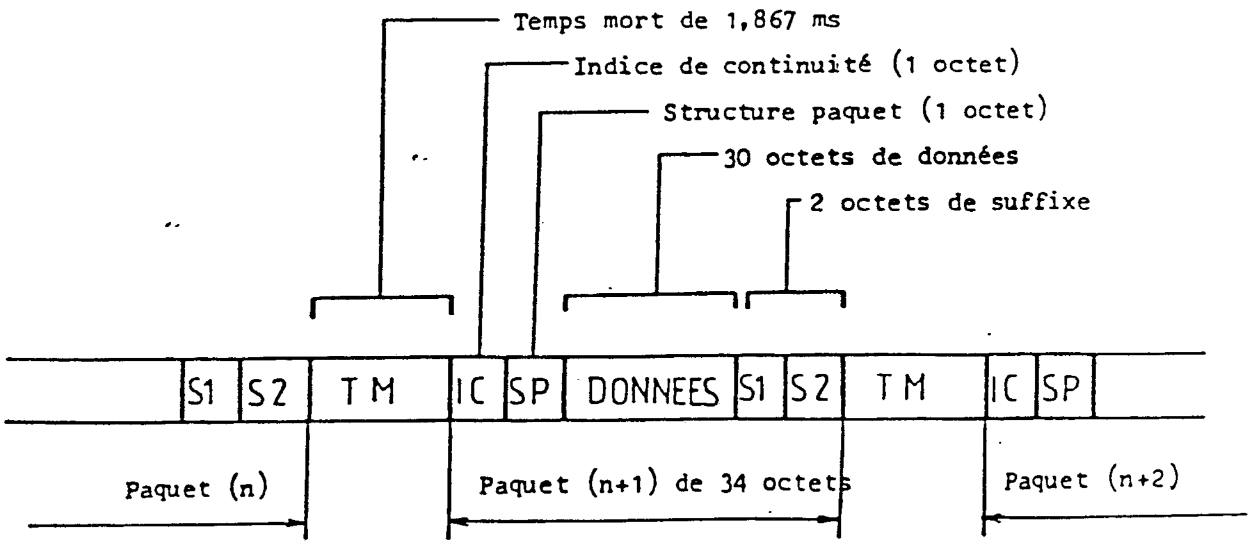
Temps mort de 1,867 ms
Indice de continuité (1 octet)
Structure paquet (1 octet)
30 octets de données
2 octets de suffixe
S1
S2
TM
IC
SP
DONNEES
S1
S2
TM
IC
SP
Paquet (n)
Paquet (n+1) de 34 octets
Paquet (n+2)

FIG. 2b

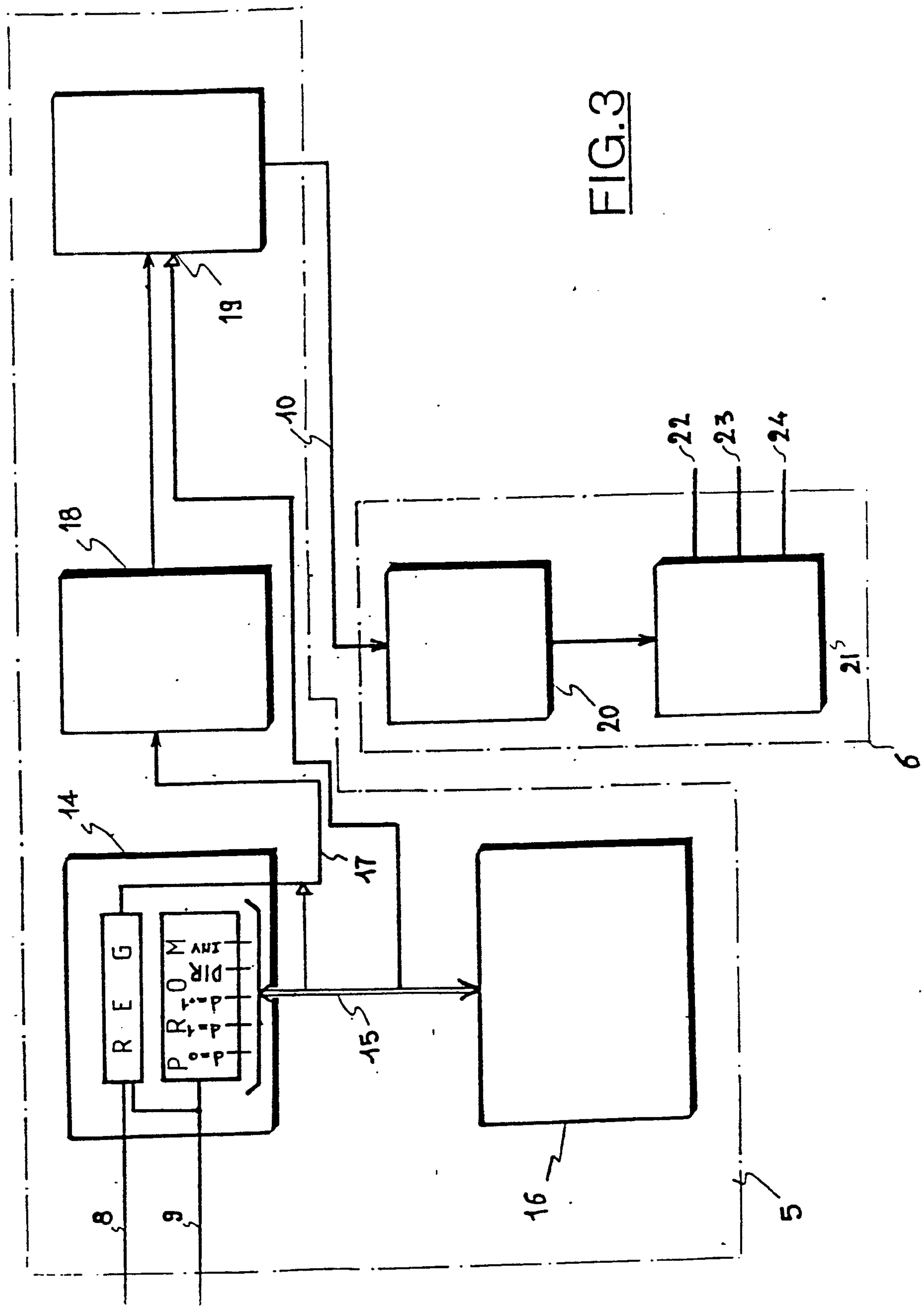


FIG.3

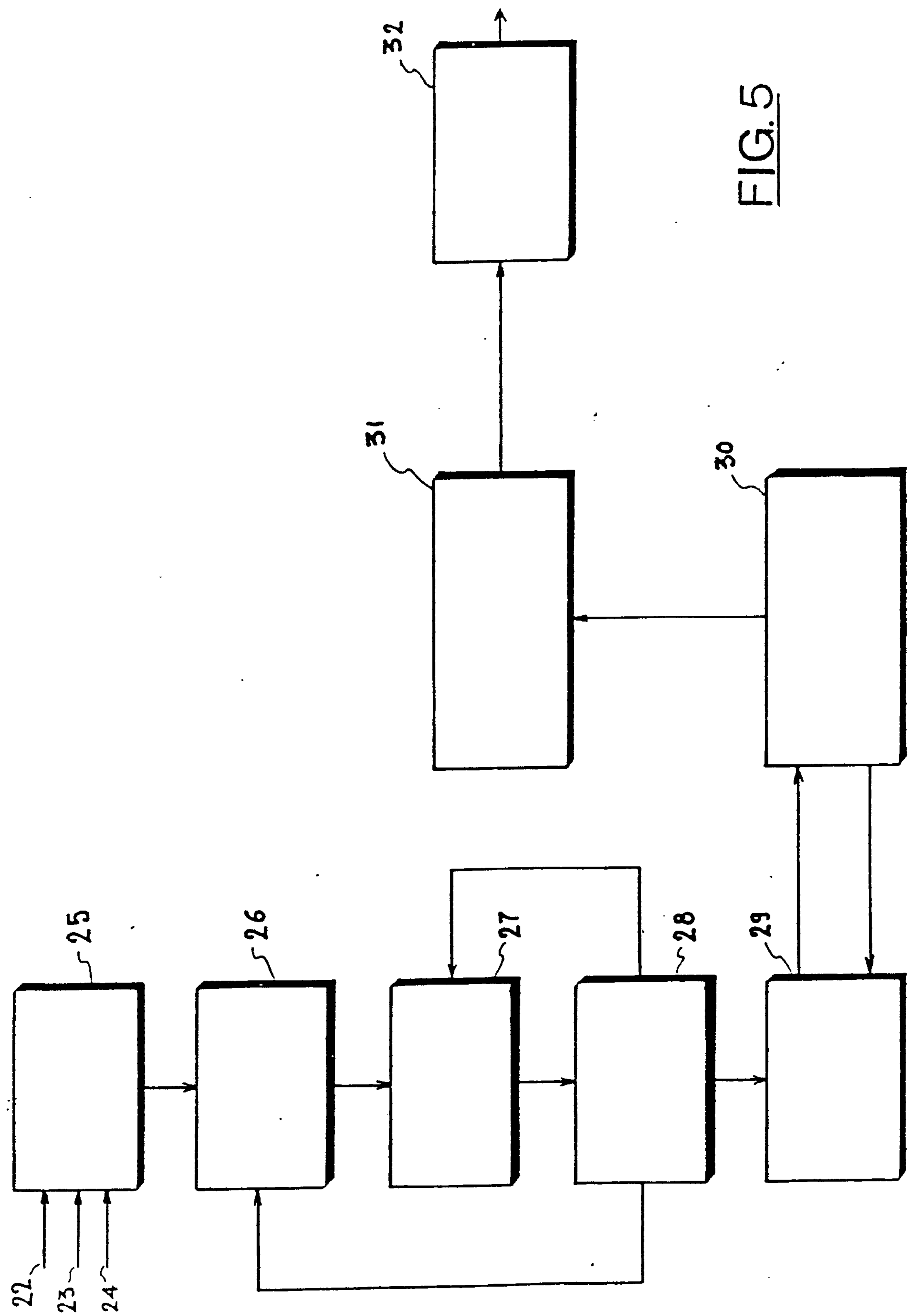


FIG. 5

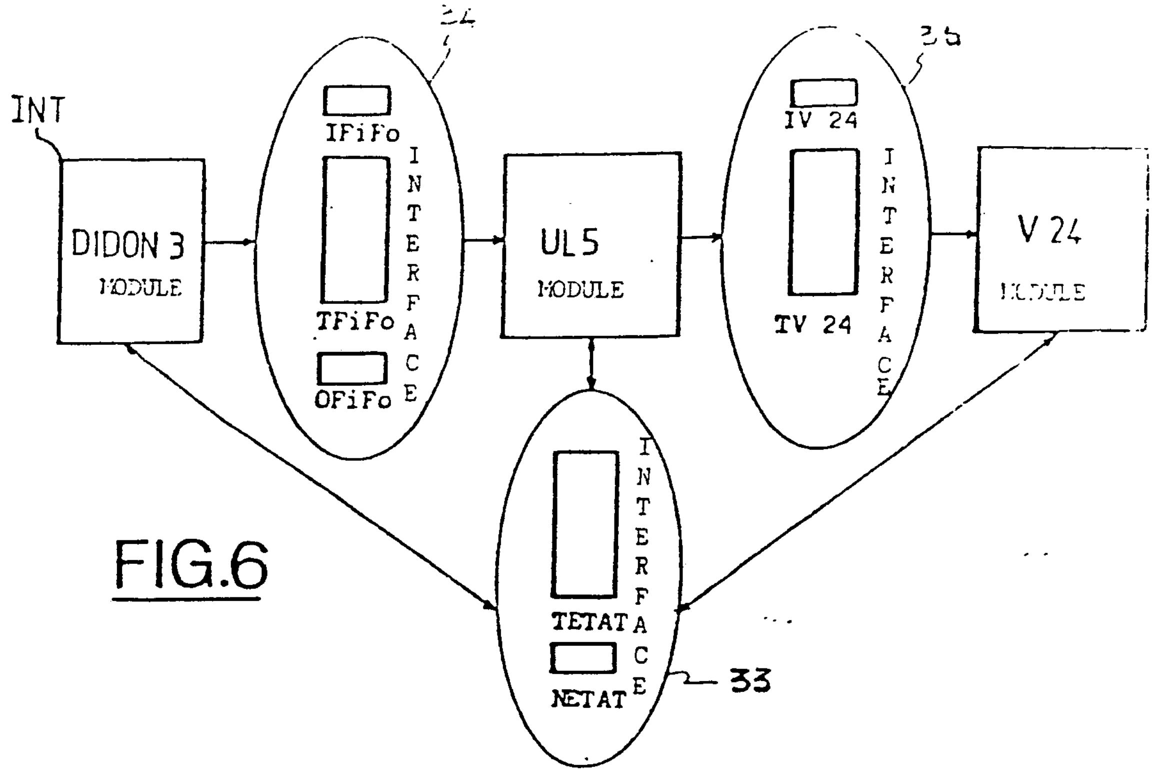


FIG.6

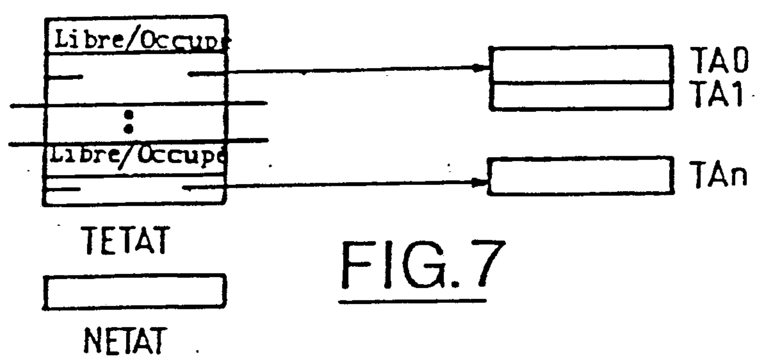


FIG.7

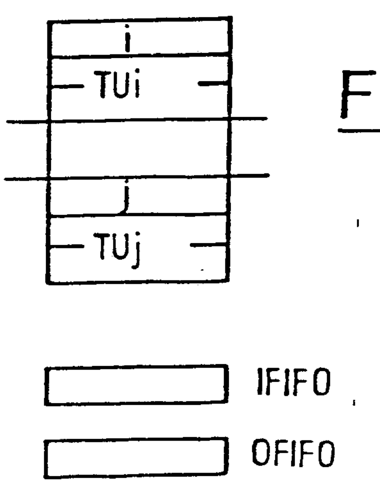


FIG.8

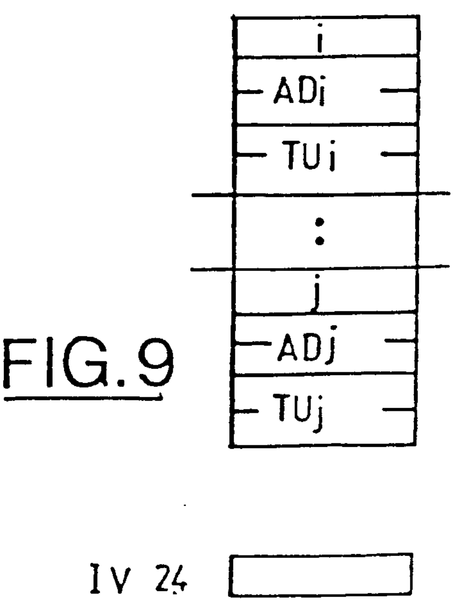


FIG.9

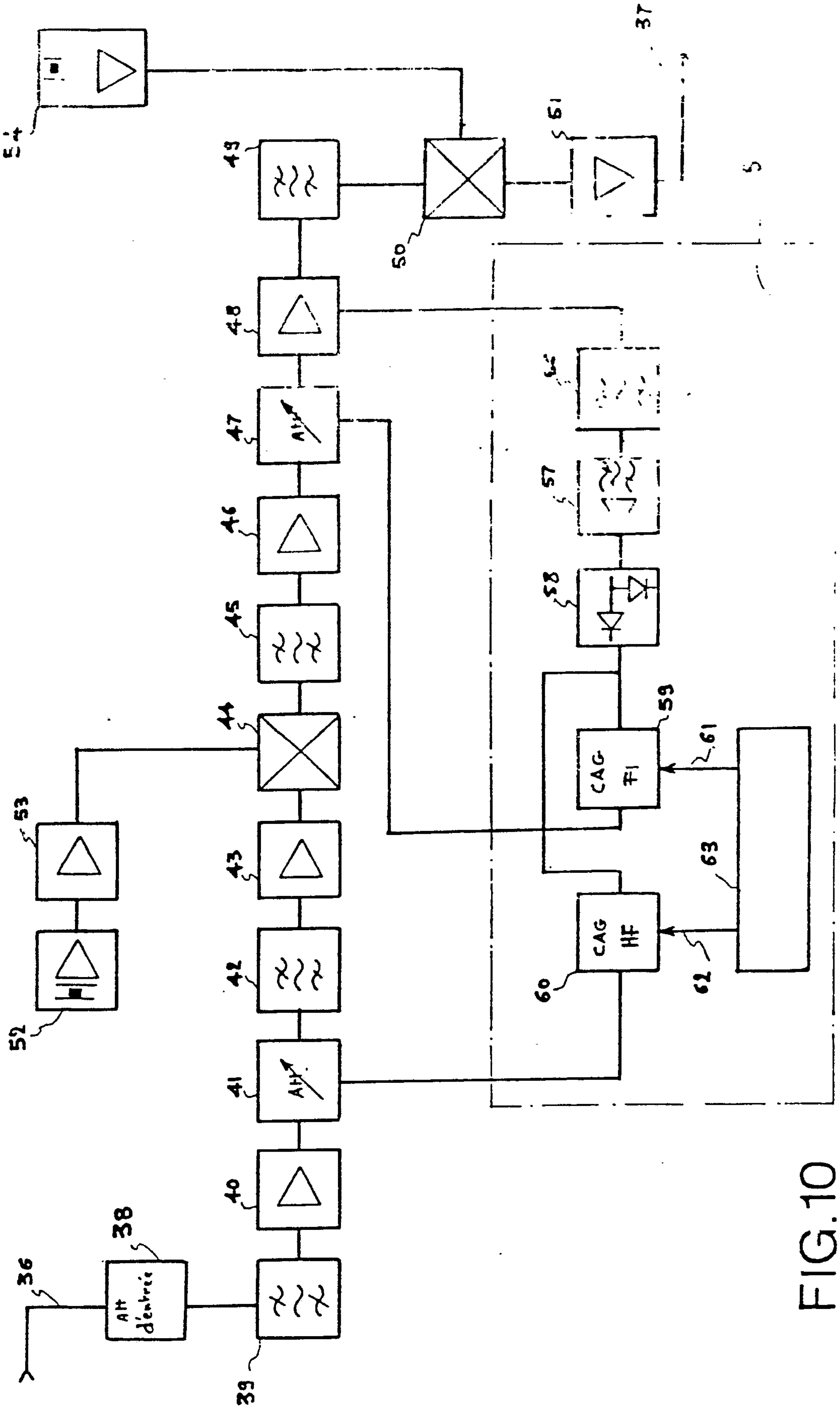
36
38
Att d'entrée
39
40
41
42
43
44
45
46
47
48
49
50
51
52
53
54
57
58
59
60
61
62
63
CAG FI
CAG HF
37

FIG.10

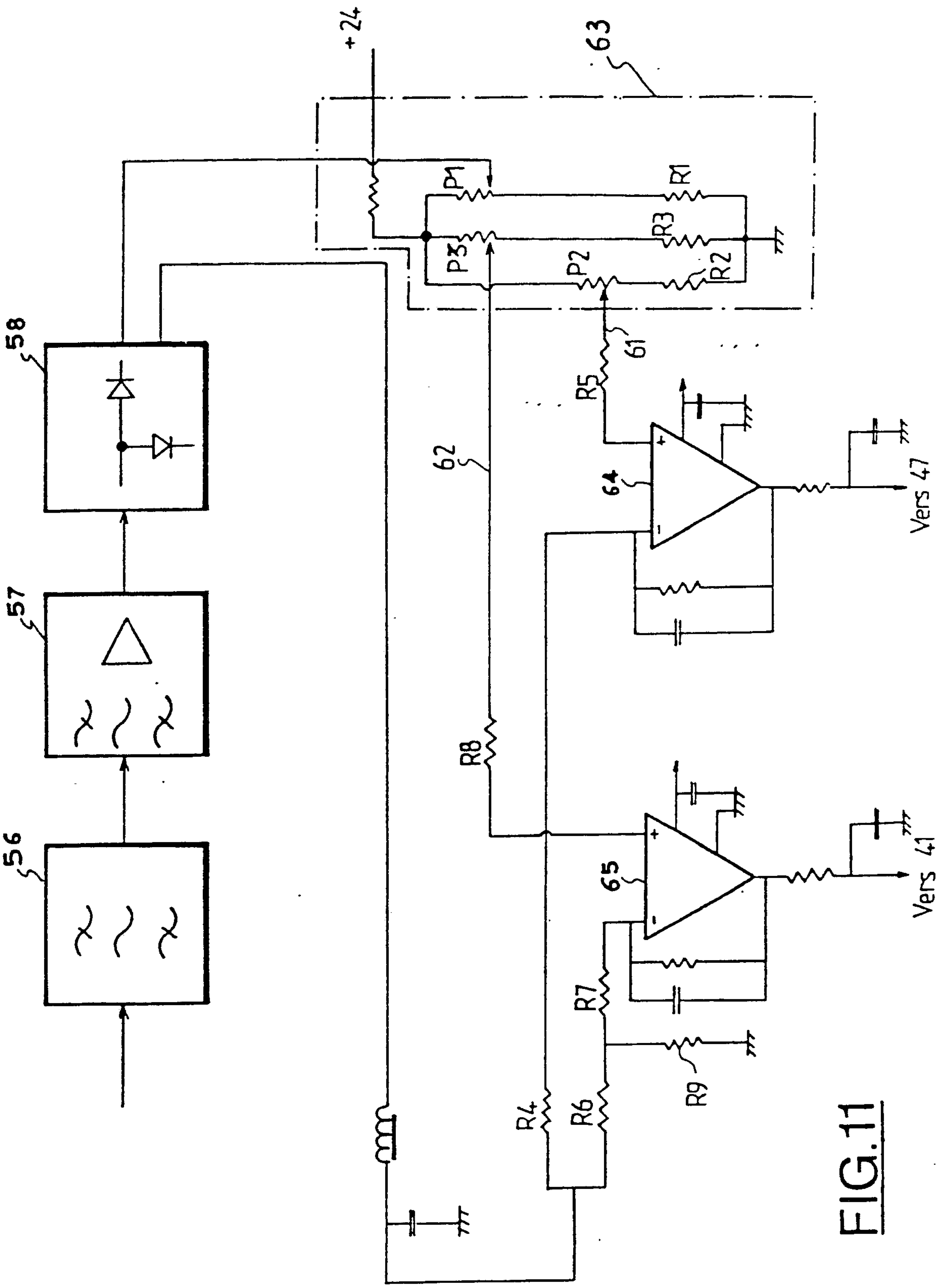
+24
63
P1
R1
P3
R3
P2
R2
58
57
56
61
R5
62
64
Vers 47
R8
65
Vers 41
R7
R9
R4
R6

FIG.11

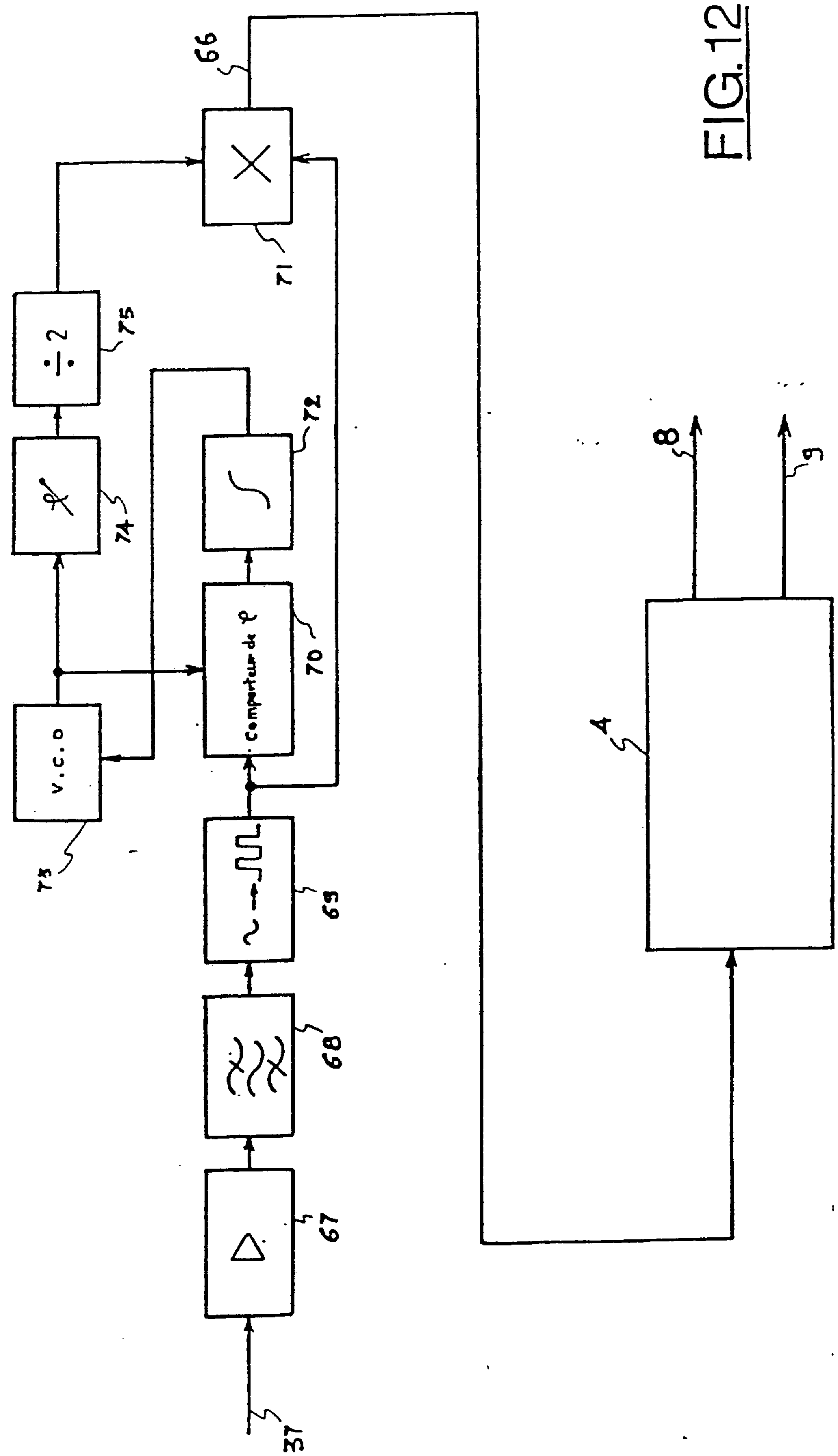


FIG.12

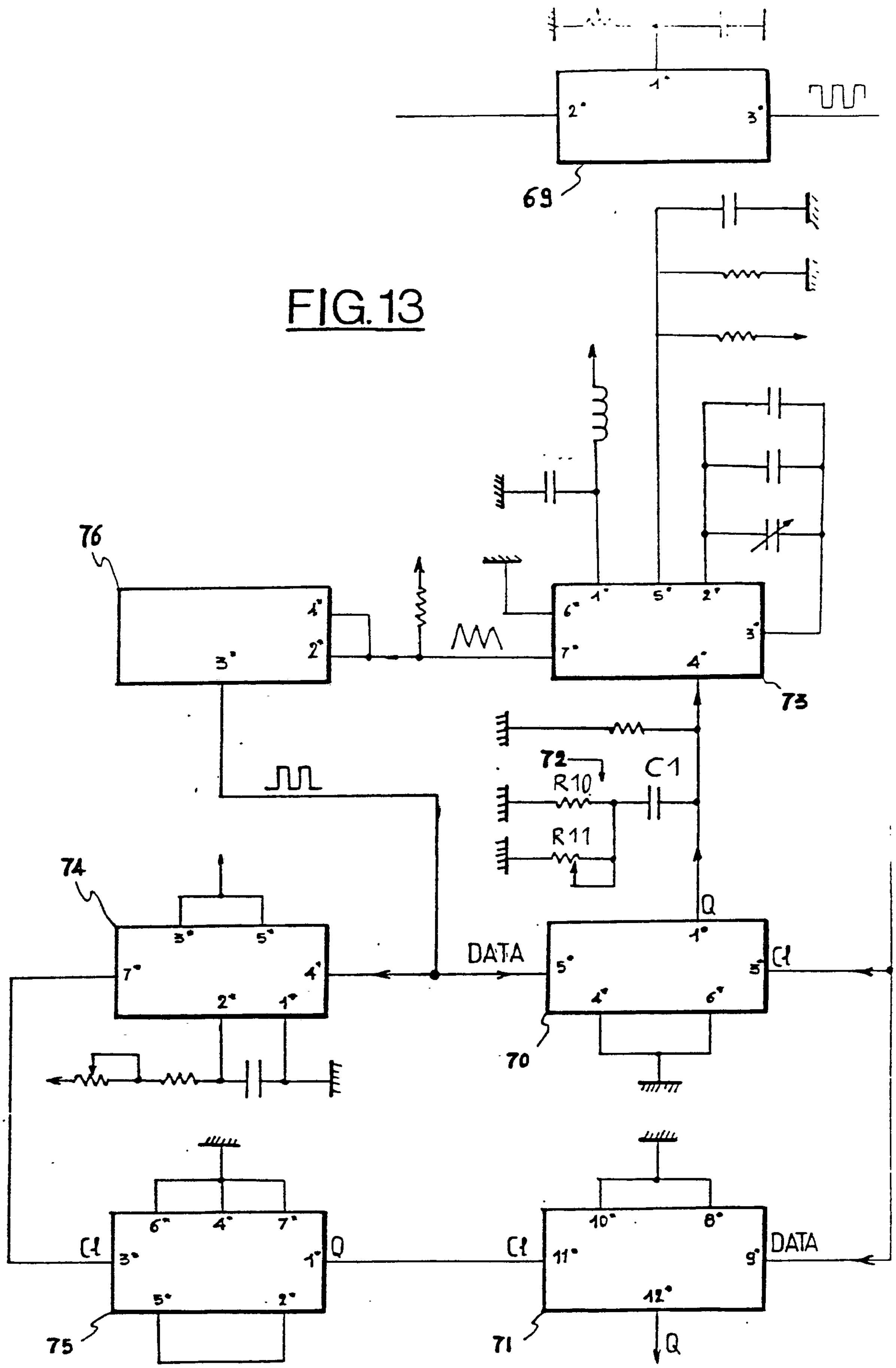

1°
2°
3°
69
5°
2°
1°
6°
7°
3°
4°
73
76
1°
2°
3°
72
R10
C1
R11
Q
74
3°
5°
7°
4°
2°
1°
DATA
5°
1°
5°
Cl
4°
6°
70
6°
4°
7°
Cl
3°
1°
Q
5°
2°
75
10°
8°
Cl
11°
9°
DATA
12°
Q
71


FIG.13

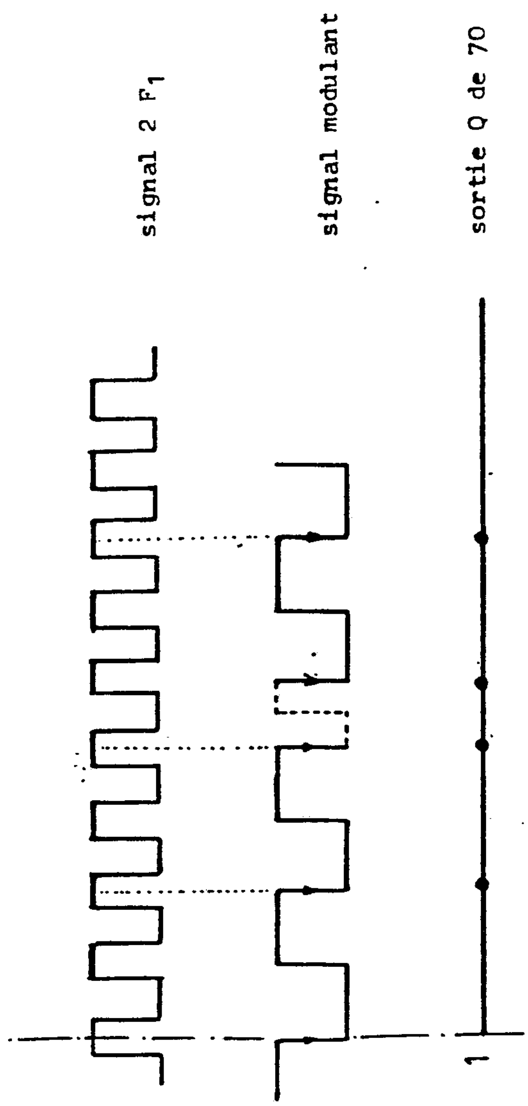


FIG.14a

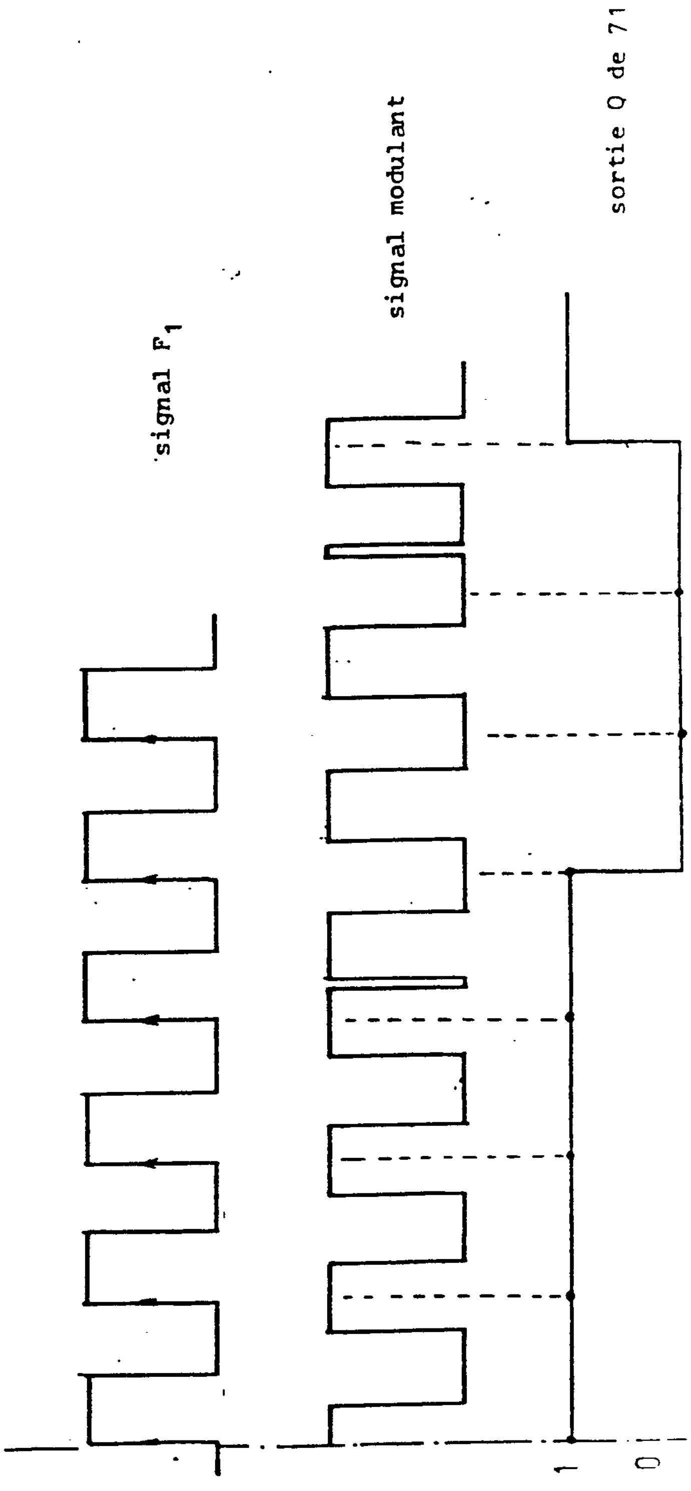


FIG.14b